(19)

Europäisches
Patentamt
European
Patent Office
Office européen
des brevets

(11) **EP 1 775 839 B1**

(12) **EUROPEAN PATENT SPECIFICATION**

(45) Date of publication and mention
of the grant of the patent:
**16.12.2009 Bulletin 2009/51**

(51) Int Cl.:
***H03M 13/11*** (2006.01)

(21) Application number: **06021762.7**

(22) Date of filing: **17.10.2006**

(54) **Method for constructing a parity check matrix of a low density parity check code**

Verfahren zur Konstruktion einer Prüfmatrix für einen Low-Density Parity-Check Kode

Procédé pour générer une matrice de contrôle de code de contrôle de parité de faible densité

(84) Designated Contracting States:
**DE FR GB IT SE**

(30) Priority: **17.10.2005 KR 20050097687**

(43) Date of publication of application:
**18.04.2007 Bulletin 2007/16**

(73) Proprietors:
• **Samsung Electronics Co., Ltd.**
**Suwon-si, Gyeonggi-do 442-743 (KR)**
• **Korea Advanced Institute of Science and**
**Technology**
**(KAIST)**
**Daejon (KR)**

(72) Inventors:
• **Kim, Dong-Ho**
**Yeongtong-gu**
**Suwon-si**
**Gyeonggi-do (KR)**
• **Lee, Ye-Hoon**
**Yeongtong-gu**
**Suwon-si**
**Gyeonggi-do (KR)**
• **You, Cheol-Woo**
**Yeongtong-gu**
**Suwon-si**
**Gyeonggi-do (KR)**
• **Kim, Nam-Shik**
**No. 101-504, Simgok Hyundai APT.**
**Gyeonggi-do (KR)**
• **Park, Hyun-Cheol**
**Daejeon (KR)**

(74) Representative: **Grünecker, Kinkeldey,**
**Stockmair & Schwanhäusser**
**Anwaltssozietät**
**Leopoldstrasse 4**
**80802 München (DE)**

(56) References cited:
**EP-A- 1 624 582**

• **JUN XU ET AL: "A combinatoric superposition method for constructing low density parity check codes" PROC. 2003 IEEE INTERNATIONAL SYMPOSIUM ON INFORMATION THEORY ISIT 03, 29 June 2003 (2003-06-29), page 30, XP010657058 Yokohama, Japan ISBN: 0-7803-7728-1**
• **CLASSON B ET AL: "LDPC coding for OFDMA PHY" INTERNET CITATION, [Online] 30 August 2004 (2004-08-30), XP002371218 Retrieved from the Internet: URL:http://ieee802.org/16> [retrieved on 2006-03-09]**
• **HAO ZHONG ET AL: "Design of VLSI implementation-oriented LDPC codes" PROC. VEHICULAR TECHNOLOGY CONFERENCE 2003, 6 October 2003 (2003-10-06), pages 670-673Vol1, XP010700823 Orlando, USA ISBN: 0-7803-7954-3**
• **HOCEVAR D E: "LDPC code construction with flexible hardware implementation" PROC. 2003 IEEE INTERNATIONAL CONFERENCE ON COMMUNICATIONS, vol. VOL. 1 OF 5, 11 May 2003 (2003-05-11), pages 2708-2712, XP010642938 Anchorage, USA ISBN: 0-7803-7802-4**

**(Cont. next page)**

EP 1 775 839 B1

- **FOSSORIER M P C: "Quasi-cyclic low-density parity-check codes from circulant permuation matrices" IEEE TRANSACTIONS ON INFORMATION THEORY, IEEE SERVICE CENTER, PISCATAWAY, NJ, US, vol. 50, no. 8, 1 August 2004 (2004-08-01), pages 1788-1793, XP002346039 ISSN: 0018-9448**

**Description**

**BACKGROUND OF THE INVENTION**

1. Field of the Invention

The present invention generally relates to channel coding technology in a communication system, and more particularly to a method for constructing a parity check matrix of a Low Density Parity Code (LDPC) code in a communication system.

2. Description of the Related Art

Because Low Density Parity Check (LDPC) codes have a superior performance and lower decoding complexity than turbo codes and can be processed in parallel at a high rate, they are attracting much interest as a coding scheme suitable for the Fourth-Generation (4G) mobile communication systems.

The LDPC codes first proposed by Gallager in 1962 are defined as linear block codes using a parity check matrix H with a large number of 0's. Since code complexity has hindered the implementation of technology to use the LDPC codes, the LDPC codes have been almost forgotten. Mackay and Neal have rediscovered the LDPC codes and have verified that they have a superior performance using a simple probabilistic decoding method of Gallager.

One of obstacle elements in implementing the LDPC code is coding complexity. The complexity of coding performed by matrix multiplication increases in proportion to the square of the length of a code. To reduce this complexity, cyclic codes have been proposed. Decoding complexity can be reduced only if a code has a sparse parity check matrix. Most of the known cyclic codes do not satisfy this condition.

Finite geometry codes have also been proposed. These codes exhibit a significantly improved iterative decoding performance through the use of cyclic characteristics and a possible sparse parity check matrix. The cyclic finite geometry codes are useful only in a limited range of the code length and rate. As a column weight increases in proportion to the code length, the decoding complexity increases.

Jun Xu et al, "A coombinatoric superposition method for constructing low density parity check codes", PROC. 2003 IEEE international Symposium on Information Theory ISIT 03, 29 June 2003, page 30, relates to a combinatoric superposition method for constructing low density parity check codes. Let $B = [b_{i,j}]$ be a binary $\alpha \times \beta$ matrix. Let $G = \{G_1, G_2, ...,G_K\}$ be a class of sparse $k \times n$ matrices which satisfies the following constraint: no two rows (or two columns) either in the same matrix $G_i$ or in two different matrices $G_i$ and $G_j$ have more than one "1-entry" in common (called the row-column constraint). Construct an $\alpha k \times \beta n$ matrix H as follows: (1) replace each 1-entry in B by a matrix in G; (2) replace each O-entry in B by a $k \times n$ zero matrix; and (3) all the non-zero sub-matrices in a row or in a column are distinct (called the replacement constraint). Then H is also sparse matrix. The null space of H gives an LDPC code. If B and all the constituent matrices of G are regular matrices, then H is a regular matrix and $C_{ns}$ is a regular LDPC code.

Classon B et al, LDPC coding for OFDMA PHY", Internet citation, 30 August 2004, retrieved from the Internet: http://ieee802.org/16 describes a system where each LDPC code in a set of LDPC codes is defined by a matrix H of size $m$-by-$n$, where $n$ is the length of the code and $m$ is the number of parity check bits in the code. The number of systematic bits is $k=n-m$. The matrix H is expanded from a base matrix $H_b$ of size $m_b$-by-$n_b$, where $n = z \cdot n_b$ and $m = z \cdot m_b$, with $z$ an integer $\geq 1$. $H_b$ is partitioned into two sections, where $H_{b1}$ corresponds to the systematic bits and $H_{b2}$ corresponds to the parity-check bits. Section $H_{b2}$ is further partitioned into two sections, where vector $h_b$ has odd weight, and $H'_{b2}$ has a dual-diagonal structure with matrix elements at row i, column $j$ equal to 1 for $i=j$, 1 for $i=j+1$, and 0 elsewhere. An expanded matrix H is created from a base matrix by replacing each 1 in the base matrix with a z-by-z non-zero sub-matrix, and each 0 with a z-by-z zero matrix. In particular, the non-zero sub-matrices are circularly right shifted by a particular circular shift value. Each 1 in $H'_{b2}$ is assigned a shift size of 0, and is replaced by a z x z identity matrix when expanding to H. The two 1 s located at the top and the bottom of $h_b$ are assigned equal shift sizes, and the third 1 in the middle of $h_b$ is given an unpaired shift.

Hao Zhong et al, "Design of VLSI implemention-oriented LDPC codes", Proc. Vehicular Technology Conference 2003, 6 October 2003, pages 670-673, Vol. 1, also deals with LDCP code design. To construct an LDPC code with an MxN parity check matrix, provided that $M = p \cdot M_s$ and $N = p \cdot N_s$, the proposed construction approach performs the following steps: (1) use a heuristic algorithm to construct a group of base parity check matrices with the size of $M_s$ x $N_s$; (2) randomly expand each base matrix into a $p \cdot M_s$ x $p \cdot N_s$ parity check matrix; (3) apply a cycle effect criterion to select an LDPC code from the developed code group. In the construction of the base matrices, it is tried to avoid small cycles as much as possible. The heuristic approach called bit-filling, proposed by Campello and Modha is adopted to construct a certain number of $M_s$ x $N_s$ base matrices whose corresponding bipartite graphs have large girths.

Hocevar D. "LDPC code construction with flexible hardware implementation", PROC. 2003 IEEE International Conference on Communications, Vol. 1 of 5, 11 May 2003, pages 2708-2712, deals with LDPC code construction with flexible hardware implementation. The approach presented is as follows. Choose the parameters needed that will work for your problem, optimize the degree distributions, construct a matrix of dimensions j x k that is populated largely with Os and sparsely with 1 s such that it closely matches the desired distributions, and lastly, replace each 0 with an m x m matrix of zeros and replace each 1 with the corresponding SFT circularly shifted permutation matrix for that position. The result is a parity check matrix.

Fossorier M., "Quasi-caclic low-density parity-check codes from circulant permutation matrices", IEEE Transactions on Information Theory, 1 August 2004, pages 1788-1793, relates to the construction of low-density parity-check (LDPC) codes from circulant permutation matrixes.

## SUMMARY OF THE INVENTION

It is the object of the invention to reduce the coding complexity of a method and system using a low-density parity-check code.

This object is solved by the present invention as claimed in the independent claims.

Preferred embodiments are defined by the dependent claims.

It is, therefore, an object of the present invention to provide a method for constructing a parity check matrix of a Low Density Parity Check (LDPC) code that can reduce the coding complexity.

It is another object of the present invention to provide a method for constructing a parity check matrix of a Low Density Parity Check (LDPC) code that can implement a parity check matrix in which a 4-cycle or 6-cycle does not occur.

It is another object of the present invention to provide a method for constructing a parity check matrix of a Low Density Parity Check (LDPC) code that can minimize the coding complexity by eliminating an inverse matrix operation during the coding process.

It is another object of the present invention to provide a method for constructing a parity check matrix of a Low Density Parity Check (LDPC) code that can construct a quasi-cyclic code having cyclic characteristics to reduce the coding complexity.

In accordance with an aspect of the present invention, there is provided a method for generating a parity check matrix of a Low Density Parity Check (LDPC) code, including generating a base matrix in which elements with a value of 1 are arranged at predefined distances; and replacing the elements with the value of 1 in the base matrix with predefmed sub-matrices and generating a parity check matrix.

The base matrix is generated by setting a code rate of the LDPC code, generating at least two Integer Distance Cyclic Matrices (IDCMs) mapped to the code rate, and arranging the at least two IDCMs. The sub-matrices are irregular sub-matrices.

## BRIEF DESCRIPTION OF THE DRAWINGS

The above and other objects and aspects of the present invention will be more clearly understood from the following detailed description taken in conjunction with the accompanying drawings, in which:

FIG. 1 illustrates an example of an Integer Distance Cyclic Matrix (IDCM) for constructing a base matrix corresponding to a basis of a Low Density Parity Check (LDPC) code in accordance with the present invention;
FIG. 2 illustrates an example of an Integer Distance Quasi-Cyclic Matrix (IDQCM) mapped to the IDCM of FIG. 1;
FIG. 3 illustrates an example of a base matrix for generating a quasi-cyclic (QC)-LDPC code with a code rate of ½ in accordance with the present invention;
FIG. 4 illustrates an example of a parity check matrix generated by replacing IDCMs for constructing the base matrix of FIG. 3 with IDQCMs; and
FIG. 5 is a flowchart illustrating a process for generating a parity check matrix in accordance with the present invention.

## DETAILED DESCRIPTION OF THE PREFERRED EMBODIMENTS

Preferred embodiments of the present invention will be described in detail herein below with reference to the accompanying drawings such that those skilled in the art can readily implement the present invention.

Hereinafter, the present invention proposes a method for constructing a parity check matrix of a Low Density Parity Check (LDPC) code. The present invention constructs a quasi-cyclic code having cyclic characteristics to reduce the coding complexity. Further, the present invention provides a method for constructing an irregular parity check matrix of an LDPC code that can improve the decoding performance by implementing a parity check matrix capable of avoiding a 4-cycle or 6-cycle when a quasi-cyclic code is constructed.

When a code rate is set in the parity check matrix construction method of the present invention, at least two Integer Distance Cyclic Matrices (IDCMs) mapped to the code rate are selected. When the selected IDCMs are combined, a base matrix is generated. When the IDCMs for constructing the base matrix are replaced with Integer Distance Quasi-Cyclic Matrices (IDQCMs) mapped thereto, a parity check matrix is generated in which a 4-cycle or 6-cylce does not occur, that is, the number of 4-cycles or 6-cycles is reduced.

The IDQCM is generated by replacing elements with the value of 1 for constructing the associated IDCM with predefined sub-matrices, i.e., irregular sub-matrices.

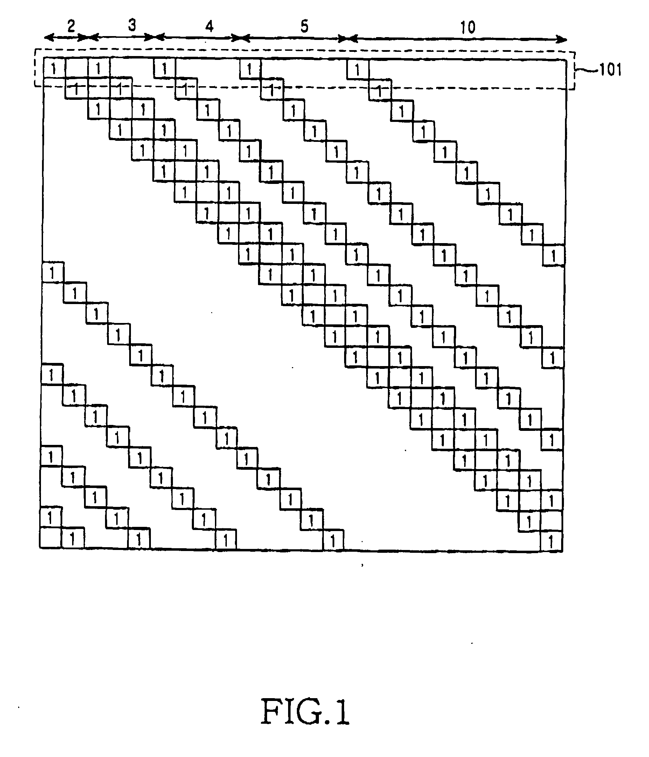

FIG. 1 illustrates an example of an IDCM for constructing a base matrix corresponding to a basis of an LDPC code in accordance with the present invention. As illustrated in FIG. 1, the IDCM is constructed by arranging elements with the value of 1 at predefined distances and shifting a generated row (codeword) 101 by 1.

In FIG. 1, the distance between the 1st and 2nd elements with the value of 1 is 2. The distance between the 2nd and 3rd elements with the value of 1 is 3. The distance between the 3rd and 4th elements with the value of 1 is 4. The distance between the 4th and 5th elements with the value of 1 is 5. The distance between the 5th and 6th elements with the value of 1 is 10. For convenience of explanation, the IDCM with the above-described distance characteristics is expressed by IDCM [2,3,4,5,10].

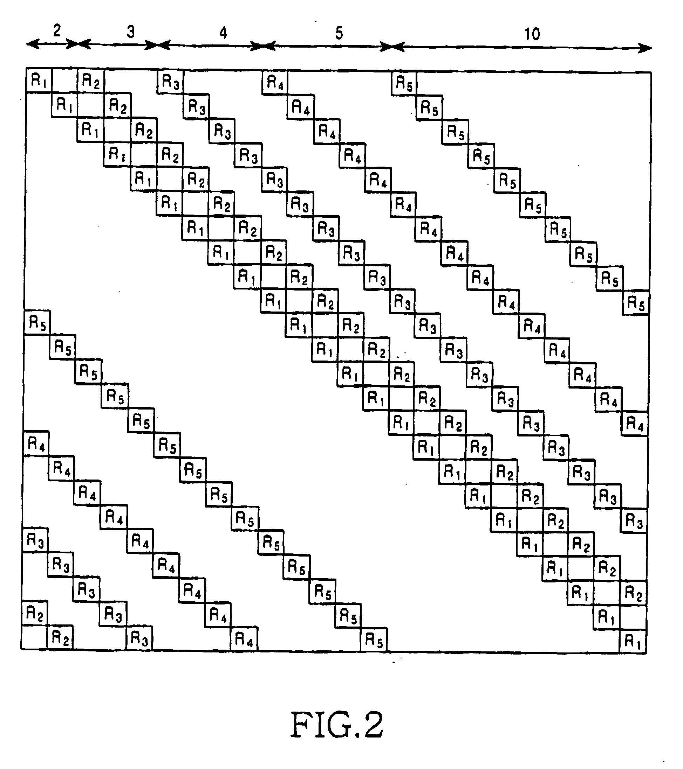

FIG. 2 illustrates an example of an IDQCM mapped to the IDCM of FIG. 1. As illustrated in FIG. 2, the 1st diagonal elements for constructing the IDCM are replaced with sub-matrices $R_1$. The 2nd diagonal elements for constructing the IDCM are replaced with sub-matrices $R_2$. The 3rd diagonal elements for constructing the IDCM are replaced with sub-matrices $R_3$. The 4th diagonal elements for constructing the IDCM are replaced with sub-matrices $R_4$. The 5th diagonal elements for constructing the IDCM are replaced with sub-matrices $R_5$. For convenience of explanation, the IDQCM with the above-described distance characteristics is expressed by IDQCM [2,3,4,5,10|$R_1,R_2,R_3,R_4,R_5$],

The sub-matrices are constructed with small-sized block matrices. The block matrices include at least one of a zero matrix, a unit matrix and a quasi-cyclic matrix generated by shifting the unit matrix to the right by a predefined value. The block matrices are irregularly constructed inside the sub-matrices. Elements with the value of 1 are irregularly distributed in the sub-matrices.

The sub-matrix is denoted by $R_i$ where $i$ is a sub-matrix index. The sub-matrix is predefined according to code rate.

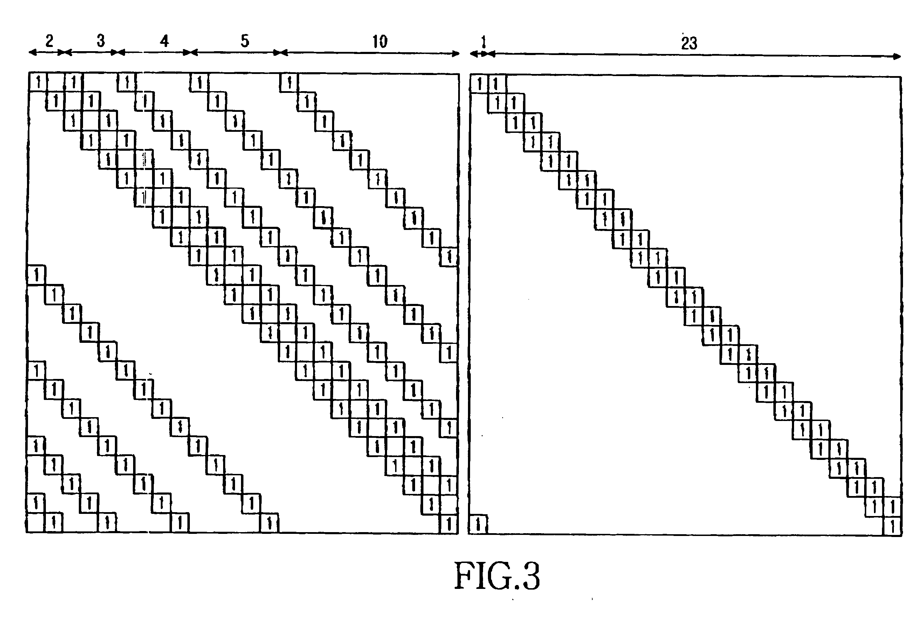

FIG. 3 illustrates an example of a base matrix for generating a Quasi-Cyclic (QC)-LDPC code with a code rate of ½ in accordance with the present invention.

As illustrated in FIG. 3, the base matrix of the QC-LDPC code with the code rate of ½ is generated by combining IDCM [2,3,4,5,10] and IDCM [1,23]. The base matrix B can be expressed as shown in Equation (1).

$$\text{B} = [\text{IDCM } [2,3,4,5,10] \mid \text{IDCM } [1,23]] \qquad ….(1)$$

In the generated base matrix, two 4-cycles, fifty-eight 6-cycles, and forty-seven 8-cycles occur.

Among elements of the base matrix, elements with the value of 1 are replaced with sub-matrices mapped to the code rate of ½ and elements with the value of 0 (not illustrated) are filled with a zero matrix that has the same size as the sub-matrix. In the code rate 1/2, 24 x 24 sub-matrix is two. Each of the IDCM integer sum is 24.

A parity check matrix H from the base matrix can be expressed as shown in Equation (2).

$$\text{H} = [\text{H1}|\text{H2}] = [\text{IDQCM } [2,3,4,5,10]|R_1,…,R_5] \mid \text{IDQCM } [1,23|R_6,R_7]] \qquad …. (2)$$

For example, sub-matrices $R_i$ of the QC-LDPC code with the code rate of ½ in accordance with the present invention are predefined as shown in Equation (3).

$$R_1 = \begin{bmatrix} 28 & 0 & 0 & 0 \\ 0 & 0 & 0 & 48 \\ 1 & 0 & 0 & 0 \\ 0 & 0 & 38 & 0 \end{bmatrix}, \quad R_2 = \begin{bmatrix} 0 & 0 & 0 & 9 \\ 39 & 0 & 0 & 0 \\ 0 & 0 & 15 & 0 \\ 0 & 2 & 0 & 0 \end{bmatrix}, \quad R_3 = \begin{bmatrix} 0 & 0 & 43 & 0 \\ 0 & 0 & 0 & 0 \\ 0 & 0 & 45 & 0 \\ 41 & 0 & 0 & 0 \end{bmatrix},$$

$$R_4 = \begin{bmatrix} 46 & 0 & 0 & 0 \\ 0 & 0 & 51 & 0 \\ 0 & 0 & 0 & 7 \\ 0 & 25 & 0 & 0 \end{bmatrix}, \quad R_5 = \begin{bmatrix} 0 & 0 & 0 & 0 \\ 0 & 0 & 13 & 0 \\ 42 & 0 & 0 & 0 \\ 0 & 0 & 47 & 0 \end{bmatrix}, \quad R_6 = \begin{bmatrix} 0 & 33 & 0 & 0 \\ 0 & 0 & 8 & 0 \\ 4 & 0 & 0 & 0 \\ 0 & 0 & 0 & 18 \end{bmatrix},$$

$$R_7 = \begin{bmatrix} 0 & 0 & 0 & 44 \\ 37 & 0 & 0 & 0 \\ 0 & 12 & 0 & 0 \\ 0 & 0 & 49 & 0 \end{bmatrix} \qquad\qquad \dots (3)$$

As described above, the sub-matrices $R_i$ are constructed with small-sized block matrices. For example, the block matrices include a zero matrix, a unit matrix and a quasi-cyclic matrix generated by shifting the unit matrix to the right by a predefined value. For example, the value of 28 or 48 shown in Equation (3) is a value by which the unit matrix is shifted to the right. In the sub-matrix $R_1$, the first column is constructed with a block matrix rather than two zero matrices and the second column is constructed with a zero matrix. Thus, elements with the value of 1 are irregularly distributed inside the sub-matrix $R_1$ constructed with the block matrixes. The parity check matrix are constructed with the sub-matrices. Ths sub-matrixes include irrgular disributed elements with the value of 1 even though a base matrix is regularly distributed. The finally generated parity check matrix is constructed such that the elements with the value of 1 are iregularly distributed.

On the other hand, to eliminate an inverse matrix operation in the coding process, a sub-matrix of the highest sub-matrix index of the last row is replaced with a predefined matrix $R_c$ for eliminating the inverse matrix operation. The matrix for eliminating the inverse matrix operation can be computed by adding an identity matrix to the sub-matrix of the highest sub-matrix index as shown in Equation (4).

$$R_c = R_{max} + I \qquad\qquad \dots (4)$$

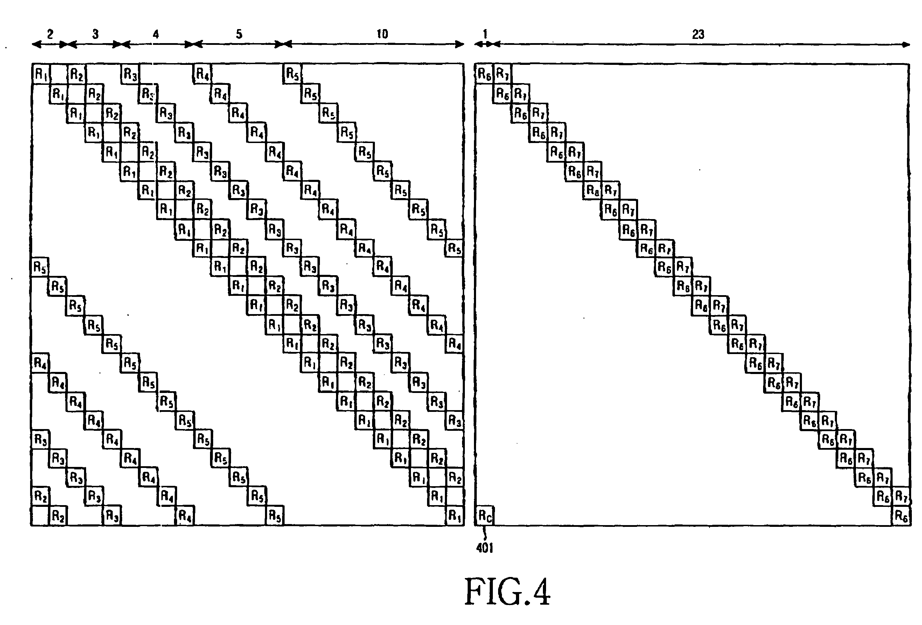

FIG. 4 illustrates an example of a parity check matrix generated by replacing IDCMs for constructing the base matrix of FIG. 3 with IDQCMs.

Among the sub-matrices for constructing IDQCM [1,23], the sub-matrix $R_7$ 401 of the highest sub-matrix index of the last row is replaced with the matrix $R_c$ for eliminating the inverse matrix operation. That is, the sub-matrix $R_7$ of the last row in the parity check matrix H of Equation (2) is included in H2, and IDQCM [1,23|$R_6$,$R_7$] mapped to H2 is rewritten as shown in Equation (5).

$$H2 = IDQCM[1,23 \mid R_6, R_7] = \begin{bmatrix} \ddots & & \ddots & & \\ & \ddots & & \ddots & \\ & & & R_6 & R_7 \\ & & & & R_6 & R_7 \\ R_c & & & & R_6 \end{bmatrix} \qquad \dots (5)$$

In the same manner as a parity check matrix process relative to the code rate of ½, a base matrix of a QC-LDPC code with a code rate of 2/3 is generated by combining IDCM [1,2,3,10], IDCM [4,5,7], and IDCM [1,15]. The base matrix B can be expressed as shown in Equation (6).

$$B = [IDCM \, [1,2,3,10] \mid IDCM \, [4,5,7] \mid IDCM \, [1,15]] \quad \dots \dots (6)$$

A parity check matrix H from the base matrix of the Equation (6) can be expressed as shown in Equation (7). In the code rate 2/3, 16 x 16 sub-matrix is three. Each of the IDCM integer sum is 16.

$$H = [H1|H2|H3] = [IDQCM \, [1,2,3,10|R_1,\dots,R_4] \mid IDQCM \, [4,5,7|R_5,R_6,R_7] \mid$$
$$IDQCM \, [1,15|R_8,R_9]] \qquad \dots (7)$$

For example, sub-matrices $R_i$ of the QC-LDPC code with the code rate 2/3 in accordance with the present invention are predefined as shown in Equation (8).

$$R_1 = \begin{bmatrix} 21 & 0 & 0 & 0 \\ 0 & 22 & 0 & 0 \\ 51 & 0 & 0 & 21 \\ 0 & 0 & 20 & 0 \end{bmatrix}, R_2 = \begin{bmatrix} 0 & 38 & 0 & 15 \\ 40 & 0 & 0 & 0 \\ 0 & 0 & 37 & 0 \\ 23 & 25 & 0 & 0 \end{bmatrix}, R_3 = \begin{bmatrix} 0 & 0 & 28 & 0 \\ 0 & 0 & 44 & 0 \\ 46 & 0 & 0 & 0 \\ 0 & 0 & 0 & 0 \end{bmatrix},$$

$$R_4 = \begin{bmatrix} 0 & 49 & 0 & 0 \\ 0 & 0 & 0 & 17 \\ 0 & 36 & 0 & 0 \\ 12 & 0 & 20 & 0 \end{bmatrix}, R_5 = \begin{bmatrix} 0 & 49 & 0 & 17 \\ 24 & 0 & 0 & 0 \\ 36 & 0 & 0 & 0 \\ 0 & 0 & 12 & 0 \end{bmatrix}, R_6 = \begin{bmatrix} 0 & 0 & 26 & 0 \\ 0 & 14 & 0 & 03 \\ 14 & 0 & 0 & 0 \\ 6 & 0 & 0 & 0 \end{bmatrix},$$

$$R_7 = \begin{bmatrix} 47 & 0 & 0 & 0 \\ 0 & 2 & 0 & 0 \\ 0 & 0 & 48 & 0 \\ 30 & 0 & 0 & 33 \end{bmatrix}, R_8 = \begin{bmatrix} 0 & 5 & 0 & 0 \\ 0 & 0 & 41 & 0 \\ 39 & 0 & 0 & 0 \\ 0 & 0 & 0 & 42 \end{bmatrix}, R_9 = \begin{bmatrix} 0 & 0 & 0 & 19 \\ 35 & 0 & 0 & 0 \\ 0 & 9 & 0 & 0 \\ 0 & 0 & 4 & 0 \end{bmatrix}$$

$$\dots (8)$$

As in the code rate of ½, the above-described sub-matirxes are constructed with small-sized block matrices.

Further, a sub-matrix of the highest sub-matrix index of the last row is replaced with a predefined matrix $R_c$ for eliminating the inverse matrix operation in the coding process. Because the sub-matrix of the highest sub-matrix index is $R_9$ in the parity check matrix for the code rate of 2/3, the matrix for eliminating the inverse matrix operation $R_c = R_9 + I$. That is, the sub-matrix $R_9$ of the last row in the parity check matrix H of Equation (7) is included in H3, and IDQCM $[1,15|R_8,R_9]$ mapped to H3 is rewritten as shown in Equation (9).

$$H3 = IDQCM[1,15 \mid R_8, R_9] = \begin{bmatrix} \ddots & & \ddots & & \\ & \ddots & & \ddots & \\ & & R_8 & R_9 & \\ & & & R_8 & R_9 \\ R_c & & & & R_8 \end{bmatrix} \quad \dots\, (9)$$

A base matrix of a QC-LDPC code with the code rate of ¾ is generated by combining IDCM [1,2,3,6], IDCM [1,4,7], IDCM [2,5,5], and IDCM [1,11]. The base matrix B can be expressed as shown in Equation (10).

$$B = [IDCM \, [1,2,3,6] \mid IDCM \, [1,4,7] \mid IDCM \, [2,5,5] \mid IDCM \, [1,11]]$$

$$\dots (10)$$

A parity check matrix H from the base matrix of the Equation (10) can be expressed as shown in Equation (11). In the code rate 3/4, 12 x 12 sub-matrix is four. Each of the IDCM integer sum is 12.

$$H = [H1|H2|H3|H4] = [IDQCM \, [1,2,3,6|R_1,\dots,R_4] \mid IDQCM \, [1,4,7|R_5,R_6,R_7] \mid IDQCM \, [2,5,5|R_8,R_9,R_{10}] \mid IDQCM \, [1,11|R_{11},R_{12}]] \quad \dots (11)$$

For example, sub-matrices $R_i$ of a QC-LDPC code with the code rate of ¾ in accordance with the present invention are predefined as shown in Equation (12).

$$R_1 = \begin{bmatrix} 50 & 0 & 2 & 0 \\ 0 & 10 & 0 & 0 \\ 67 & 0 & 0 & 50 \\ 0 & 0 & 40 & 0 \end{bmatrix}, \quad R_2 = \begin{bmatrix} 0 & 18 & 0 & 58 \\ 56 & 0 & 0 & 0 \\ 0 & 0 & 48 & 0 \\ 8 & 60 & 0 & 0 \end{bmatrix}, \quad R_3 = \begin{bmatrix} 0 & 0 & 17 & 0 \\ 0 & 55 & 0 & 0 \\ 70 & 0 & 0 & 0 \\ 0 & 0 & 30 & 0 \end{bmatrix},$$

$$R_4 = \begin{bmatrix} 0 & 5 & 0 & 0 \\ 0 & 0 & 29 & 35 \\ 0 & 11 & 0 & 0 \\ 38 & 0 & 0 & 0 \end{bmatrix}, \quad R_5 = \begin{bmatrix} 0 & 0 & 0 & 46 \\ 0 & 27 & 0 & 0 \\ 0 & 0 & 22 & 0 \\ 23 & 0 & 0 & 0 \end{bmatrix}, \quad R_6 = \begin{bmatrix} 0 & 15 & 0 & 0 \\ 0 & 0 & 0 & 39 \\ 49 & 0 & 0 & 0 \\ 0 & 0 & 24 & 0 \end{bmatrix},$$

$$R_7 = \begin{bmatrix} 44 & 0 & 0 & 0 \\ 0 & 0 & 0 & 21 \\ 0 & 0 & 16 & 0 \\ 0 & 31 & 0 & 0 \end{bmatrix}, \quad R_8 = \begin{bmatrix} 0 & 0 & 0 & 41 \\ 0 & 47 & 0 & 0 \\ 0 & 0 & 52 & 0 \\ 63 & 0 & 0 & 0 \end{bmatrix}, \quad R_9 = \begin{bmatrix} 0 & 0 & 54 & 0 \\ 0 & 10 & 0 & 34 \\ 7 & 0 & 0 & 0 \\ 0 & 64 & 0 & 0 \end{bmatrix},$$

$$R_{10} = \begin{bmatrix} 0 & 28 & 0 & 0 \\ 0 & 0 & 0 & 25 \\ 13 & 0 & 0 & 0 \\ 0 & 0 & 4 & 0 \end{bmatrix}, \quad R_{11} = \begin{bmatrix} 0 & 36 & 0 & 0 \\ 0 & 0 & 43 & 0 \\ 42 & 0 & 0 & 0 \\ 0 & 0 & 0 & 71 \end{bmatrix}, \quad R_{12} = \begin{bmatrix} 0 & 0 & 0 & 45 \\ 53 & 0 & 0 & 0 \\ 0 & 6 & 0 & 0 \\ 0 & 0 & 62 & 0 \end{bmatrix},$$

$$....(12)$$

Also in this case, the sub-matrices are constructed with small-sized block matrices.

Further, a sub-matrix of the highest sub-matrix index of the last row is replaced with a predefined matrix $R_c$ for eliminating the inverse matrix operation in the coding process. A matrix ($R_c = R_{12} = +I$) for eliminating an inverse matrix operation is computed from the sub-matrix of the highest sub-matrix index in a parity check matrix for the code rate of ¾. The sub-matrix $R_{12}$ of the last row in the parity check matrix H of Equation (11) is included in H4, and IDQCM [1,11|$R_{11}$, $R_{12}$] mapped to H4 is rewritten as shown in Equation (13).

$$H4 = IDQCM[1,11 \mid R11, R12] = \begin{bmatrix} R11 & R12 & & & & \\ & \ddots & & \ddots & & \\ & & R11 & R12 & \\ & & & R11 & R12 \\ Rc & & & & R11 \end{bmatrix} ....$$

$$(13)$$

The parity check matrix can be generated by a parity check matrix generator (not illustrated) in a communication system. Next, a process for generating the parity check matrix will be briefly described.

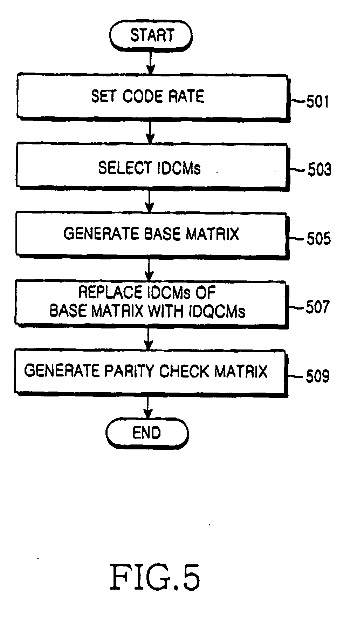

FIG. 5 is a flowchart illustrating the process for generating the parity check matrix in accordance with the present invention.

Referring to FIG. 5, the parity check matrix generator sets a code rate for generating the parity check matrix in step 501 and then proceeds to step 503.

The parity check matrix generator selects at least two IDCMs mapped to the set code rate in step 503 and then proceeds to step 505.

The parity check matrix generator generates a base matrix by combining the selected IDCMs in step 505 and then proceeds to step 507.

The parity check matrix generator replaces IDCMs forming the base matrix with IDQCMs mapped thereto in step 507 and then proceeds to step 509.

The IDQCMs are generated by replacing elements with the value of 1 constructing the IDCMs with at least one predefined sub-matrix, i.e., irregular sub-matrices. The sub-matrices are constructed with small-sized block matrices. The block matrices include at least one of a zero matrix, a unit matrix and a quasi-cyclic matrix generated by shifting the unit matrix to the right by a predefined value. In this case, the sub-matrices are irregular sub-matrices in which the block matrices are constructed irregularly.

Further, the parity check matrix generator replaces a sub-matrix of the highest sub-matrix index of the last row with a predefined matrix for eliminating the inverse matrix operation. The matrix for eliminating the inverse matrix operation can be generated by adding an identity matrix to the sub-matrix of the highest sub-matrix index of the last row among the sub-matrices. That is, the inverse matrix operation is eliminated using the matrix for eliminating the inverse matrix operation during the coding process.

In step 509, the parity check matrix generator generates a parity check matrix through the replacement such that a 4-cycle or 6-cylce does not occur.

As is apparent from the above description, an LDPC code construction method of the present invention can improve the decoding performance by implementing a parity check matrix from which 4-cycles or 6-cycles that adversely affect the LDPC code performance are completely eliminated.

Moreover, the LDPC code construction method of the present invention can minimize the coding complexity by eliminating an inverse matrix operation in a coding process.

**Claims**

1.  A channel coding method in a communication system, the method including generating a parity check matrix of a Low Density Parity Check, LDPC, code and comprising the steps of:

    setting (501) a code rate of the LDPC code, wherein the code rate is ½;
    generating (503) a first 24x24 Integer Distance Cyclic Matrix, IDCM, mapped to the code rate of ½, wherein five elements with a value of 1 are arranged at the columns 1, 3, 6, 10, and 15 in the first row and at columns cyclically right-shifted by 1 in each successive row, resulting in the elements with the value of 1 of the first IDCM being arranged on diagonal lines starting at the columns 1, 3, 6, 10, and 15;
    generating (503) a second 24x24 IDCM mapped to the code rate of ½, wherein two elements with a value of 1 are arranged at the columns 1 and 2 in the first row and at columns cyclically right-shifted by 1 in each successive row, resulting in the elements with the value of 1 of the second IDCM being arranged on diagonal lines starting at the columns 1 and 2;
    generating (505) a base matrix by combining the first and second IDCMs; and
    generating the parity check matrix by:

        replacing (507) the IDCMs constructing the base matrix with Integer Distance Quasi-Cyclic Matrices, IDQCMs, constructed by replacing the elements with the value of 1 on the diagonal lines starting at the columns 1, 3, 6, 10, and 15 in the first row of the first IDCM with irregular block sub-matrices $R_1$, $R_2$, $R_3$, $R_4$, and $R_5$, respectively, and by replacing the elements with the value of 1 on the diagonal lines starting at the columns 1 and 2 in the first row of the second IDCM with irregular block sub-matrices $R_6$ and $R_7$, respectively, resulting in a modified base matrix,
        wherein the irregular block sub-matrices are defined by:

$$R_1 = \begin{bmatrix} 28 & 0 & 0 & 0 \\ 0 & 0 & 0 & 48 \\ 1 & 0 & 0 & 0 \\ 0 & 0 & 38 & 0 \end{bmatrix}, \quad R_2 = \begin{bmatrix} 0 & 0 & 0 & 9 \\ 39 & 0 & 0 & 0 \\ 0 & 0 & 15 & 0 \\ 0 & 2 & 0 & 0 \end{bmatrix}, \quad R_3 = \begin{bmatrix} 0 & 0 & 43 & 0 \\ 0 & 0 & 0 & 0 \\ 0 & 0 & 45 & 0 \\ 41 & 0 & 0 & 0 \end{bmatrix}, \quad R_4 = \begin{bmatrix} 46 & 0 & 0 & 0 \\ 0 & 0 & 51 & 0 \\ 0 & 0 & 0 & 7 \\ 0 & 25 & 0 & 0 \end{bmatrix},$$

$$R_5 = \begin{bmatrix} 0 & 0 & 0 & 0 \\ 0 & 0 & 13 & 0 \\ 42 & 0 & 0 & 0 \\ 0 & 0 & 47 & 0 \end{bmatrix}, \quad R_6 = \begin{bmatrix} 0 & 33 & 0 & 0 \\ 0 & 0 & 8 & 0 \\ 4 & 0 & 0 & 0 \\ 0 & 0 & 0 & 18 \end{bmatrix}, \text{ and } R_7 = \begin{bmatrix} 0 & 0 & 0 & 44 \\ 37 & 0 & 0 & 0 \\ 0 & 12 & 0 & 0 \\ 0 & 0 & 49 & 0 \end{bmatrix},$$

wherein the blocks labelled "0" indicate zero matrices, the blocks labelled "1" indicate unit matrices, and the blocks labelled by an integer larger than 1 indicate unit matrices that have been cyclically right-shifted by the respective integer; and

replacing (509) the sub-matrix $R_7$ in the last row of the modified base matrix with a replacement matrix generated by adding an identity matrix to the sub-matrix $R_7$.

2. A channel coding method in a communication system, the method including generating a parity check matrix of a Low Density Parity Check, LDPC, code and comprising the steps of:

setting (501) a code rate of the LDPC code, wherein the code rate is 2/3;

generating (503) a first 16x16 Integer Distance Cyclic Matrix, IDCM, mapped to the code rate of 2/3, wherein four elements with a value of 1 are arranged at the columns 1, 2, 4, and 7 in the first row and at columns cyclically right-shifled by 1 in each successive row, resulting in the elements with the value of 1 of the first IDCM being arranged on diagonal lines starting at the columns 1, 2, 4, and 7;

generating (503) a second 16x16 IDCM mapped to the code rate of 2/3, wherein three elements with a value of 1 are arranged at the columns 1, 5, and 10 in the first row and at columns cyclically right-shifted by 1 in each successive row, resulting in the elements with the value of 1 of the second IDCM being arranged on diagonal lines starting at the columns 1, 5, and 10;

generating (503) a third 16x16 IDCM mapped to the code rate of 2/3, wherein two elements with a value of 1 are arranged at the columns 1 and 2 in the first row and at columns cyclically right-shifted by 1 in each successive row, resulting in the elements with the value of 1 of the third IDCM being arranged on diagonal lines starting at the columns 1 and 2;

generating (505) a base matrix by combining the first, second, and third IDCMs; and

generating the parity check matrix by:

replacing (507) the IDCMs constructing the base matrix with Integer Distance Quasi-Cyclic Matrices, IDQCMs, constructed by replacing the elements with the value of 1 on the diagonal lines starting at the columns 1, 2, 4, and 7 in the first row of the first IDCM with irregular block sub-matrices $R_1$, $R_2$, $R_3$, and $R_4$, respectively, by replacing the elements with the value of 1 on the diagonal lines starting at the columns 1, 5, and 10 in the first row of the second IDCM with irregular block sub-matrices $R_5$, $R_6$, and $R_7$, respectively, and by replacing the elements with the value of 1 on the diagonal lines starting at the columns 1 and 2 in the first row of the third IDCM with irregular block sub-matrices $R_8$ and $R_9$, respectively, resulting in a modified base matrix,

wherein the irregular block sub-matrices are defined by:

$$R_1 = \begin{bmatrix} 21 & 0 & 0 & 0 \\ 0 & 22 & 0 & 0 \\ 51 & 0 & 0 & 21 \\ 0 & 0 & 20 & 0 \end{bmatrix}, R_2 = \begin{bmatrix} 0 & 38 & 0 & 15 \\ 40 & 0 & 0 & 0 \\ 0 & 0 & 37 & 0 \\ 23 & 25 & 0 & 0 \end{bmatrix}, R_3 = \begin{bmatrix} 0 & 0 & 28 & 0 \\ 0 & 0 & 44 & 0 \\ 46 & 0 & 0 & 0 \\ 0 & 0 & 0 & 0 \end{bmatrix},$$

$$R_4 = \begin{bmatrix} 0 & 49 & 0 & 0 \\ 0 & 0 & 0 & 17 \\ 0 & 36 & 0 & 0 \\ 12 & 0 & 20 & 0 \end{bmatrix}, R_5 = \begin{bmatrix} 0 & 49 & 0 & 17 \\ 24 & 0 & 0 & 0 \\ 36 & 0 & 0 & 0 \\ 0 & 0 & 12 & 0 \end{bmatrix}, R_6 = \begin{bmatrix} 0 & 0 & 26 & 0 \\ 0 & 14 & 0 & 03 \\ 14 & 0 & 0 & 0 \\ 6 & 0 & 0 & 0 \end{bmatrix},$$

$$R_7 = \begin{bmatrix} 47 & 0 & 0 & 0 \\ 0 & 2 & 0 & 0 \\ 0 & 0 & 48 & 0 \\ 30 & 0 & 0 & 33 \end{bmatrix}, R_8 = \begin{bmatrix} 0 & 5 & 0 & 0 \\ 0 & 0 & 41 & 0 \\ 39 & 0 & 0 & 0 \\ 0 & 0 & & 42 \end{bmatrix}, \text{ and } R_9 = \begin{bmatrix} 0 & 0 & 0 & 19 \\ 35 & 0 & 0 & 0 \\ 0 & 9 & 0 & 0 \\ 0 & 0 & 4 & 0 \end{bmatrix},$$

wherein the blocks labelled "0" indicate zero matrices, the blocks labelled "1" indicate unit matrices, and the blocks labelled by an integer larger than 1 indicate unit matrices that have been cyclically right-shifted by the respective integer; and

replacing (509) the sub-matrix $R_9$ in the last row of the modified base matrix with a replacement matrix generated by adding an identity matrix to the sub-matrix $R_9$.

3. A channel coding method in a communication system, the method including generating a parity check matrix of a Low Density Parity Check, LDPC, code and comprising the steps of:

setting (501) a code rate of the LDPC code, wherein the code rate is 3/4;

generating (503) a first 12x12 Integer Distance Cyclic Matrix, IDCM, mapped to the code rate of 3/4, wherein four elements with a value of 1 are arranged at the columns 1, 2, 4, and 7 in the first row and at columns cyclically right-shifted by 1 in each successive row, resulting in the elements with the value of 1 of the first IDCM being arranged on diagonal lines starting at the columns 1, 2, 4, and 7;

generating (503) a second 12x12 IDCM mapped to the code rate of 3/4, wherein three elements with a value of 1 are arranged at the columns 1, 2, and 6 in the first row and at columns cyclically right-shifted by 1 in each successive row, resulting in the elements with the value of 1 of the second IDCM being arranged on diagonal lines starting at the columns 1, 2, and 6;

generating (503) a third 12x12 IDCM mapped to the code rate of 3/4, wherein three elements with a value of 1 are arranged at the columns 1, 3, and 8 in the first row and at columns cyclically right-shifted by 1 in each successive row, resulting in the elements with the value of 1 of the third IDCM being arranged on diagonal lines starting at the columns 1, 3, and 8;

generating (503) a fourth 12x12 IDCM mapped to the code rate of 3/4, wherein two elements with a value of 1 are arranged at the columns 1 and 2 in the first row and at columns cyclically right-shifted by 1 in each successive row, resulting in the elements with the value of 1 of the fourth IDCM being arranged on diagonal lines starting at the columns 1 and 2;

generating (505) a base matrix by combining the first, second, third, and fourth IDCMs; and generating the parity check matrix by:

replacing (507) the IDCMs constructing the base matrix with Integer Distance Quasi-Cyclic Matrices, IDQCMs, constructed by replacing the elements with the value of 1 on the diagonal lines starting at the columns 1, 2, 4, and 7 in the first row of the first IDCM with irregular block sub-matrices $R_1$, $R_2$, $R_3$, and $R_4$, respectively, by replacing the elements with the value of 1 on the diagonal lines starting at the columns 1, 2, and 6 in the first row of the second IDCM with irregular block sub-matrices $R_5$, $R_6$, and $R_7$, respectively, by replacing the elements with the value of 1 on the diagonal lines starting at the columns 1, 3, and 8 in the first row of the third IDCM with irregular block sub-matrices $R_8$, $R_9$, and $R_{10}$, respectively, and by replacing the elements with the value of 1 on the diagonal lines starting at the columns 1 and 2 in the first row of the fourth IDCM with irregular block sub-matrices $R_{11}$ and $R_{12}$, respectively, resulting in a modified base matrix, wherein the irregular block sub-matrices are defined by:

$$R_1 = \begin{bmatrix} 50 & 0 & 2 & 0 \\ 0 & 10 & 0 & 0 \\ 67 & 0 & 0 & 50 \\ 0 & 0 & 40 & 0 \end{bmatrix}, \quad R_2 = \begin{bmatrix} 0 & 18 & 0 & 58 \\ 56 & 0 & 0 & 0 \\ 0 & 0 & 48 & 0 \\ 8 & 60 & 0 & 0 \end{bmatrix}, \quad R_3 = \begin{bmatrix} 0 & 0 & 17 & 0 \\ 0 & 55 & 0 & 0 \\ 70 & 0 & 0 & 0 \\ 0 & 0 & 30 & 0 \end{bmatrix},$$

$$R_4 = \begin{bmatrix} 0 & 5 & 0 & 0 \\ 0 & 0 & 29 & 35 \\ 0 & 11 & 0 & 0 \\ 38 & 0 & 0 & 0 \end{bmatrix}, \quad R_5 = \begin{bmatrix} 0 & 0 & 0 & 46 \\ 0 & 27 & 0 & 0 \\ 0 & 0 & 22 & 0 \\ 23 & 0 & 0 & 0 \end{bmatrix}, \quad R_6 = \begin{bmatrix} 0 & 15 & 0 & 0 \\ 0 & 0 & 0 & 39 \\ 49 & 0 & 0 & 0 \\ 0 & 0 & 24 & 0 \end{bmatrix},$$

$$R_7 = \begin{bmatrix} 44 & 0 & 0 & 0 \\ 0 & 0 & 0 & 21 \\ 0 & 0 & 16 & 0 \\ 0 & 31 & 0 & 0 \end{bmatrix}, \quad R_8 = \begin{bmatrix} 0 & 0 & 0 & 41 \\ 0 & 47 & 0 & 0 \\ 0 & 0 & 52 & 0 \\ 63 & 0 & 0 & 0 \end{bmatrix}, \quad R_9 = \begin{bmatrix} 0 & 0 & 54 & 0 \\ 0 & 10 & 0 & 34 \\ 7 & 0 & 0 & 0 \\ 0 & 64 & 0 & 0 \end{bmatrix},$$

$$R_{10} = \begin{bmatrix} 0 & 28 & 0 & 0 \\ 0 & 0 & 0 & 25 \\ 13 & 0 & 0 & 0 \\ 0 & 0 & 4 & 0 \end{bmatrix}, \quad R_{11} = \begin{bmatrix} 0 & 36 & 0 & 0 \\ 0 & 0 & 43 & 0 \\ 42 & 0 & 0 & 0 \\ 0 & 0 & 0 & 71 \end{bmatrix}, \text{ and } R_{12} = \begin{bmatrix} 0 & 0 & 0 & 45 \\ 53 & 0 & 0 & 0 \\ 0 & 6 & 0 & 0 \\ 0 & 0 & 62 & 0 \end{bmatrix},$$

wherein the blocks labelled "0" indicate zero matrices, the blocks labelled "1" indicate unit matrices, and the blocks labelled by an integer larger than 1 indicate unit matrices that have been cyclically right-shifted by the respective integer; and

replacing (509) the sub-matrix $R_{12}$ in the last row of the modified base matrix with a replacement matrix generated by adding an identity matrix to the sub-matrix $R_{12}$.

4. A channel coding communication system including a parity check matrix generator generating a parity check matrix of a Low Density Parity Check, LDPC, code and comprising:

means for setting (501) a code rate of the LDPC code, wherein the code rate is ½;
means for generating (503) a first 24x24 Integer Distance Cyclic Matrix, IDCM, mapped to the code rate of ½, wherein five elements with a value of 1 are arranged at the columns 1, 3, 6, 10, and 15 in the first row and at columns cyclically right-shifted by 1 in each successive row, resulting in the elements with the value of 1 of the first IDCM being arranged on diagonal lines starting at the columns 1, 3, 6, 10, and 15;
means for generating (503) a second 24x24 IDCM mapped to the code rate of ½, wherein two elements with a value of 1 are arranged at the columns 1 and 2 in the first row and at columns cyclically right-shifted by 1 in each successive row, resulting in the elements with the value of 1 of the second IDCM being arranged on diagonal lines starting at the columns 1 and 2;
means for generating (505) a base matrix by combining the first and second DCMs; and
means for generating the parity check matrix by:

replacing (507) the IDCMs constructing the base matrix with Integer Distance Quasi-Cyclic Matrices, IDQCMs, constructed by replacing the elements with the value of 1 on the diagonal lines starting at the columns 1, 3, 6, 10, and 15 in the first row of the first IDCM with irregular block sub-matrices $R_1$, $R_2$, $R_3$, $R_4$, and $R_5$, respectively, and by replacing the elements with the value of 1 on the diagonal lines starting at the columns 1 and 2 in the first row of the second IDCM with irregular block sub-matrices $R_6$ and $R_7$, respectively, resulting in a modified base matrix,

wherein the irregular block sub-matrices are defined by:

$$R_1 = \begin{bmatrix} 28 & 0 & 0 & 0 \\ 0 & 0 & 0 & 48 \\ 1 & 0 & 0 & 0 \\ 0 & 0 & 38 & 0 \end{bmatrix}, \; R_2 = \begin{bmatrix} 0 & 0 & 0 & 9 \\ 39 & 0 & 0 & 0 \\ 0 & 0 & 15 & 0 \\ 0 & 2 & 0 & 0 \end{bmatrix}, \; R_3 = \begin{bmatrix} 0 & 0 & 43 & 0 \\ 0 & 0 & 0 & 0 \\ 0 & 0 & 45 & 0 \\ 41 & 0 & 0 & 0 \end{bmatrix}, \; R_4 = \begin{bmatrix} 46 & 0 & 0 & 0 \\ 0 & 0 & 51 & 0 \\ 0 & 0 & 0 & 7 \\ 0 & 25 & 0 & 0 \end{bmatrix},$$

$$R_5 = \begin{bmatrix} 0 & 0 & 0 & 0 \\ 0 & 0 & 13 & 0 \\ 42 & 0 & 0 & 0 \\ 0 & 0 & 47 & 0 \end{bmatrix}, \; R_6 = \begin{bmatrix} 0 & 33 & 0 & 0 \\ 0 & 0 & 8 & 0 \\ 4 & 0 & 0 & 0 \\ 0 & 0 & 0 & 18 \end{bmatrix}, \; \text{and} \; R_7 = \begin{bmatrix} 0 & 0 & 0 & 44 \\ 37 & 0 & 0 & 0 \\ 0 & 12 & 0 & 0 \\ 0 & 0 & 49 & 0 \end{bmatrix},$$

wherein the blocks labelled "0" indicate zero matrices, the blocks labelled "1" indicate unit matrices, and the blocks labelled by an integer larger than 1 indicate unit matrices that have been cyclically right-shifted by the respective integer; and

replacing (509) the sub-matrix $R_7$ in the last row of the modified base matrix with a replacement matrix generated by adding an identity matrix to the sub-matrix $R_7$.

5. A channel coding communication system including a parity check matrix generator generating a parity check matrix of a Low Density Parity Check, LDPC, code and comprising:

means for setting (501) a code rate of the LDPC code, wherein the code rate is 2/3;
means for generating (503) a first 16x16 Integer Distance Cyclic Matrix, IDCM, mapped to the code rate of 2/3, wherein four elements with a value of 1 are arranged at the columns 1, 2, 4, and 7 in the first row and at columns cyclically right-shifted by 1 in each successive row, resulting in the elements with the value of 1 of the first IDCM being arranged on diagonal lines starting at the columns 1, 2, 4, and 7;
means for generating (503) a second 16x16 IDCM mapped to the code rate of 2/3, wherein three elements with a value of 1 are arranged at the columns 1, 5, and 10 in the first row and at columns cyclically right-shifted by 1 in each successive row, resulting in the elements with the value of 1 of the second IDCM being arranged on diagonal lines starting at the columns 1, 5, and 10;
means for generating (503) a third 16x16 IDCM mapped to the code rate of 2/3, wherein two elements with a value of 1 are arranged at the columns 1 and 2 in the first row and at columns cyclically right-shifted by 1 in each successive row, resulting in the elements with the value of 1 of the third IDCM being arranged on diagonal lines starting at the columns 1 and 2;
means for generating (505) a base matrix by combining the first, second, and third IDCMs; and
means for generating the parity check matrix by:

replacing (507) the IDCMs constructing the base matrix with Integer Distance Quasi-Cyclic Matrices, IDQCMs, constructed by replacing the elements with the value of 1 on the diagonal lines starting at the columns 1, 2, 4, and 7 in the first row of the first IDCM with irregular block sub-matrices $R_1$, $R_2$, $R_3$, and $R_4$, respectively, by replacing the elements with the value of 1 on the diagonal lines starting at the columns 1, 5, and 10 in the first row of the second IDCM with irregular block sub-matrices $R_5$, $R_6$, and $R_7$, respectively, and by replacing the elements with the value of 1 on the diagonal lines starting at the columns 1 and 2 in the first row of the third IDCM with irregular block sub-matrices $R_8$ and $R_9$, respectively, resulting in a modified base matrix,

wherein the irregular block sub-matrices are defined by:

$$R_1 = \begin{bmatrix} 21 & 0 & 0 & 0 \\ 0 & 22 & 0 & 0 \\ 51 & 0 & 0 & 21 \\ 0 & 0 & 20 & 0 \end{bmatrix}, R_2 = \begin{bmatrix} 0 & 38 & 0 & 15 \\ 40 & 0 & 0 & 0 \\ 0 & 0 & 37 & 0 \\ 23 & 25 & 0 & 0 \end{bmatrix}, R_3 = \begin{bmatrix} 0 & 0 & 28 & 0 \\ 0 & 0 & 44 & 0 \\ 46 & 0 & 0 & 0 \\ 0 & 0 & 0 & 0 \end{bmatrix},$$

$$R_4 = \begin{bmatrix} 0 & 49 & 0 & 0 \\ 0 & 0 & 0 & 17 \\ 0 & 36 & 0 & 0 \\ 12 & 0 & 20 & 0 \end{bmatrix}, R_5 = \begin{bmatrix} 0 & 49 & 0 & 17 \\ 24 & 0 & 0 & 0 \\ 36 & 0 & 0 & 0 \\ 0 & 0 & 12 & 0 \end{bmatrix}, R_6 = \begin{bmatrix} 0 & 0 & 26 & 0 \\ 0 & 14 & 0 & 03 \\ 14 & 0 & 0 & 0 \\ 6 & 0 & 0 & 0 \end{bmatrix},$$

$$R_7 = \begin{bmatrix} 47 & 0 & 0 & 0 \\ 0 & 2 & 0 & 0 \\ 0 & 0 & 48 & 0 \\ 30 & 0 & 0 & 33 \end{bmatrix}, R_8 = \begin{bmatrix} 0 & 5 & 0 & 0 \\ 0 & 0 & 41 & 0 \\ 39 & 0 & 0 & 0 \\ 0 & 0 & & 42 \end{bmatrix}, \text{ and } R_9 = \begin{bmatrix} 0 & 0 & 0 & 19 \\ 35 & 0 & 0 & 0 \\ 0 & 9 & 0 & 0 \\ 0 & 0 & 4 & 0 \end{bmatrix},$$

wherein the blocks labelled "0" indicate zero matrices, the blocks labelled "1" indicate unit matrices, and the blocks labelled by an integer larger than 1 indicate unit matrices that have been cyclically right-shifted by the respective integer; and

replacing (509) the sub-matrix $R_9$ in the last row of the modified base matrix with a replacement matrix generated by adding an identity matrix to the sub-matrix $R_9$.

6. A channel coding communication system including a parity check matrix generator generating a parity check matrix of a Low Density Parity Check, LDPC, code and comprising:

means for setting (501) a code rate of the LDPC code, wherein the code rate is 3/4;
means for generating (503) a first 12x12 Integer Distance Cyclic Matrix, IDCM, mapped to the code rate of 3/4, wherein four elements with a value of 1 are arranged at the columns 1, 2, 4, and 7 in the first row and at columns cyclically right-shifted by 1 in each successive row, resulting in the elements with the value of 1 of the first IDCM being arranged on diagonal lines starting at the columns 1, 2, 4, and 7;
means for generating (503) a second 12x12 IDCM mapped to the code rate of 3/4, wherein three elements with a value of 1 are arranged at the columns 1, 2, and 6 in the first row and at columns cyclically right-shifted by 1 in each successive row, resulting in the elements with the value of 1 of the second IDCM being arranged on diagonal lines starting at the columns 1, 2, and 6;
means for generating (503) a third 12x12 IDCM mapped to the code rate of 3/4, wherein three elements with a value of 1 are arranged at the columns 1, 3, and 8 in the first row and at columns cyclically right-shifted by 1 in each successive row, resulting in the elements with the value of 1 of the third IDCM being arranged on diagonal lines starting at the columns 1, 3, and 8;
means for generating (503) a fourth 12x12 IDCM mapped to the code rate of 3/4, wherein two elements with a value of 1 are arranged at the columns 1 and 2 in the first row and at columns cyclically right-shifted by 1 in each successive row, resulting in the elements with the value of 1 of the fourth IDCM being arranged on diagonal lines starting at the columns 1 and 2;
means for generating (505) a base matrix by combining the first, second, third, and fourth IDCMs; and
means for generating the parity check matrix by:

replacing (507) the IDCMs constructing the base matrix with Integer Distance Quasi-Cyclic Matrices, IDQCMs, constructed by replacing the elements with the value of 1 on the diagonal lines starting at the columns 1, 2, 4, and 7 in the first row of the first IDCM with irregular block sub-matrices $R_1, R_2, R_3$, and $R_4$, respectively, by replacing the elements with the value of 1 on the diagonal lines starting at the columns 1, 2, and 6 in the first row of the second IDCM with irregular block sub-matrices $R_5, R_6$, and $R_7$, respectively, by replacing the elements with the value of 1 on the diagonal lines starting at the columns 1, 3, and 8 in the first row of the third IDCM with irregular block sub-matrices $R_8, R_9$, and $R_{10}$, respectively, and by replacing the elements with the value of 1 on the diagonal lines starting at the columns 1 and 2 in the first row of the fourth IDCM with irregular block sub-matrices $R_{11}$ and $R_{12}$, respectively, resulting in a modified base matrix, wherein the irregular block sub-matrices are defined by:

$$R_1 = \begin{bmatrix} 50 & 0 & 2 & 0 \\ 0 & 10 & 0 & 0 \\ 67 & 0 & 0 & 50 \\ 0 & 0 & 40 & 0 \end{bmatrix}, R_2 = \begin{bmatrix} 0 & 18 & 0 & 58 \\ 56 & 0 & 0 & 0 \\ 0 & 0 & 48 & 0 \\ 8 & 60 & 0 & 0 \end{bmatrix}, R_3 = \begin{bmatrix} 0 & 0 & 17 & 0 \\ 0 & 55 & 0 & 0 \\ 70 & 0 & 0 & 0 \\ 0 & 0 & 30 & 0 \end{bmatrix},$$

$$R_4 = \begin{bmatrix} 0 & 5 & 0 & 0 \\ 0 & 0 & 29 & 35 \\ 0 & 11 & 0 & 0 \\ 38 & 0 & 0 & 0 \end{bmatrix}, R_5 = \begin{bmatrix} 0 & 0 & 0 & 46 \\ 0 & 27 & 0 & 0 \\ 0 & 0 & 22 & 0 \\ 23 & 0 & 0 & 0 \end{bmatrix}, R_6 = \begin{bmatrix} 0 & 15 & 0 & 0 \\ 0 & 0 & 0 & 39 \\ 49 & 0 & 0 & 0 \\ 0 & 0 & 24 & 0 \end{bmatrix},$$

$$R_7 = \begin{bmatrix} 44 & 0 & 0 & 0 \\ 0 & 0 & 0 & 21 \\ 0 & 0 & 16 & 0 \\ 0 & 31 & 0 & 0 \end{bmatrix}, R_8 = \begin{bmatrix} 0 & 0 & 0 & 41 \\ 0 & 47 & 0 & 0 \\ 0 & 0 & 52 & 0 \\ 63 & 0 & 0 & 0 \end{bmatrix}, R_9 = \begin{bmatrix} 0 & 0 & 54 & 0 \\ 0 & 10 & 0 & 34 \\ 7 & 0 & 0 & 0 \\ 0 & 64 & 0 & 0 \end{bmatrix},$$

$$R_{10} = \begin{bmatrix} 0 & 28 & 0 & 0 \\ 0 & 0 & 0 & 25 \\ 13 & 0 & 0 & 0 \\ 0 & 0 & 4 & 0 \end{bmatrix}, R_{11} = \begin{bmatrix} 0 & 36 & 0 & 0 \\ 0 & 0 & 43 & 0 \\ 42 & 0 & 0 & 0 \\ 0 & 0 & 0 & 71 \end{bmatrix}, \text{ and } R_{12} = \begin{bmatrix} 0 & 0 & 0 & 45 \\ 53 & 0 & 0 & 0 \\ 0 & 6 & 0 & 0 \\ 0 & 0 & 62 & 0 \end{bmatrix},$$

wherein the blocks labelled "0" indicate zero matrices, the blocks labelled "1" indicate unit matrices, and the blocks labelled by an integer larger than 1 indicate unit matrices that have been cyclically right-shifted by the respective integer; and
replacing (509) the sub-matrix $R_{12}$ in the last row of the modified base matrix with a replacement matrix generated by adding an identity matrix to the sub-matrix $R_{12}$.

**Patentansprüche**

1. Kanalcodierverfahren in einem Kommunikationssystem, wobei das Verfahren Erzeugen einer Paritätsprüfungs-Matrix eines LDPC-Codes (Low Density Parity Check Code) einschließt und die folgenden Schritte umfasst:

Festlegen (501) einer Coderate des LDPC-Codes, wobei die Coderate 1/2 beträgt;
Erzeugen (503) einer ersten 24x24-IDCM (Integer Distance Cyclic Matrix), übertragen auf die Coderate von 1/2, wobei in der ersten Reihe fünf Elemente mit einem Wert 1 in den Spalten 1, 3, 6, 10 und 15 und in jeder folgenden Reihe in Spalten angeordnet werden, die um 1 zyklisch nach rechts verschoben sind, so dass die Elemente der ersten IDCM mit dem Wert 1 auf diagonalen Linien angeordnet sind, die in den Spalten 1, 3, 6, 10 und 15 beginnen;
Erzeugen (503) einer zweiten 24x24-IDCM, übertragen auf die Coderate von 1/2, wobei in der ersten Reihe zwei Elemente mit einem Wert 1 in den Spalten 1 und 2 und in jeder folgenden Reihe in Spalten angeordnet werden, die um 1 zyklisch rechts verschoben sind, so dass die Elemente der zweiten IDCM mit dem Wert 1 auf diagonalen Linien angeordnet sind, die in den Spalten 1 und 2 beginnen;
Erzeugen (505) einer Basismatrix durch Kombinieren der ersten und der zweiten IDCM; und
Erzeugen der Paritätsprüfungs-Matrix durch:

Ersetzen (507) der IDCM, die die Basismatrix bilden, durch IDQCM (Integer Distance Quasi-Cyclic Matrices), die gebildet werden, indem die Elemente mit dem Wert 1 auf den diagonalen Linien, die in den Spalten 1, 3, 6, 10 und 15 in der ersten Reihe der ersten IDCM beginnen, durch unregelmäßige Block-Teilmatrizen $R_1$, $R_2$, $R_3$, $R_4$ bzw. $R_5$ ersetzt werden und indem die Elemente mit dem Wert 1 auf den diagonalen Linien, die in den Spalten 1 und 2 in der ersten Reihe der zweiten IDCM beginnen, durch unregelmäßige Block-Teilmatrizen $R_6$ bzw. $R_7$ ersetzt werden, so dass eine modifizierte Basismatrix entsteht,
wobei die unregelmäßigen Block-Teilmatrizen definiert sind durch:

$$R_1 = \begin{bmatrix} 28 & 0 & 0 & 0 \\ 0 & 0 & 0 & 48 \\ 1 & 0 & 0 & 0 \\ 0 & 0 & 38 & 0 \end{bmatrix}, \; R_2 = \begin{bmatrix} 0 & 0 & 0 & 9 \\ 39 & 0 & 0 & 0 \\ 0 & 0 & 15 & 0 \\ 0 & 2 & 0 & 0 \end{bmatrix}, \; R_3 = \begin{bmatrix} 0 & 0 & 43 & 0 \\ 0 & 0 & 0 & 0 \\ 0 & 0 & 45 & 0 \\ 41 & 0 & 0 & 0 \end{bmatrix}, \; R_4 = \begin{bmatrix} 46 & 0 & 0 & 0 \\ 0 & 0 & 51 & 0 \\ 0 & 0 & 0 & 7 \\ 0 & 25 & 0 & 0 \end{bmatrix},$$

$$R_5 = \begin{bmatrix} 0 & 0 & 0 & 0 \\ 0 & 0 & 13 & 0 \\ 42 & 0 & 0 & 0 \\ 0 & 0 & 47 & 0 \end{bmatrix}, \; R_6 = \begin{bmatrix} 0 & 33 & 0 & 0 \\ 0 & 0 & 8 & 0 \\ 4 & 0 & 0 & 0 \\ 0 & 0 & 0 & 18 \end{bmatrix}, \; \text{und} \; R_7 = \begin{bmatrix} 0 & 0 & 0 & 44 \\ 37 & 0 & 0 & 0 \\ 0 & 12 & 0 & 0 \\ 0 & 0 & 49 & 0 \end{bmatrix},$$

wobei die mit "0" **gekennzeichnet**en Blöcke Null-Matrizen anzeigen, die mit "1" **gekennzeichnet**en Blöcke Eins-Matrizen anzeigen und die mit einer ganzen Zahl größer als 1 **gekennzeichnet**en Blöcke Eins-Matrizen anzeigen, die um die jeweilige ganze Zahl zyklisch nach rechts verschoben worden sind; und
Ersetzen (509) der Teilmatrix $R_7$ in der letzten Reihe der modifizierten Basismatrix durch eine Ersatzmatrix, die erzeugt wird, indem eine Identitäts-Matrix zu der Teilmatrix $R_7$ addiert wird.

2. Kanalcodierverfahren in einem Kommunikationssystem, wobei das Verfahren Erzeugen einer Paritätsprüfungsmatrix eines LDPC-Codes (Low Density Parity Check Code) einschließt und die folgenden Schritte umfasst:

Festlegen (501) einer Code-Rate LDPC-Codes, wobei die Coderate 2/3 beträgt;
Erzeugen (503) einer ersten 16x16-IDCM (Integer Distance Cyclic Matrix), übertragen auf die Coderate von 2/3, wobei in der ersten Reihe vier Elemente mit einem Wert 1 in den Spalten 1, 2, 4 und 7 und in jeder folgenden Reihe in Spalten angeordnet werden, die um 1 zyklisch nach rechts verschoben sind, so dass die Elemente der ersten IDCM mit dem Wert 1 auf diagonalen Linien angeordnet sind, die in den Spalten 1, 2, 4 und 7 beginnen;
Erzeugen (503) einer zweiten 16x16-IDCM, übertragen auf die Coderate von 2/3, wobei in der ersten Reihe drei Elemente mit einem Wert 1 in den Spalten 1, 5 und 10 und in jeder folgenden Reihe in Spalten angeordnet werden, die um 1 zyklisch rechts verschoben sind, so dass die Elemente der zweiten IDCM mit dem Wert 1 auf diagonalen Linien angeordnet sind, die in den Spalten 1, 5 und 10 und beginnen;
Erzeugen (503) einer dritten 16x16-IDCM, übertragen auf die Coderate von 2/3, wobei in der ersten Reihe zwei Elemente mit einem Wert 1 in den Spalten 1 und 2 und in jeder folgenden Reihe in Spalten angeordnet sind, die um 1 zyklisch nach rechts verschoben sind, so dass die Elemente mit dem Wert 1 der dritten IDCM auf diagonalen Linien angeordnet sind, die in den Spalten 1 und 2 beginnen;
Erzeugen (505) einer Basismatrix durch Kombinieren der ersten, der zweiten und der dritten IDCM; und
Erzeugen der Paritätsprüfungs-Matrix durch:

Ersetzen (507) der IDCM, die die Basismatrix bilden, durch IDQCM (Integer Distance Quasi-Cyclic Matrices), die gebildet werden, indem die Elemente mit dem Wert 1 auf den diagonalen Linien, die in den Spalten 1, 2, 4 und 7 in der ersten Reihe der ersten IDCM beginnen, durch unregelmäßige Block-Teilmatrizen $R_1$, $R_2$, $R_3$, bzw. $R_4$ ersetzt werden und indem die Elemente mit dem Wert 1 auf den diagonalen Linien, die in den Spalten 1, 5 und 10 in der ersten Reihe der zweiten IDCM beginnen, durch unregelmäßige Block-Teilmatrizen $R_5$, $R_6$ bzw. $R_7$ ersetzt werden und indem die Elemente mit dem Wert 1 auf den diagonalen Linien, die in den Spalten 1 und 2 in der ersten Reihe der dritten IDCM beginnen, durch unregelmäßige Block-Teilmatrizen $R_8$ bzw $R_9$ ersetzt werden, so dass eine modifizierte Basismatrix entsteht,
wobei die unregelmäßigen Block-Teilmatrizen definiert sind durch:

$$R_1 = \begin{bmatrix} 21 & 0 & 0 & 0 \\ 0 & 22 & 0 & 0 \\ 51 & 0 & 0 & 21 \\ 0 & 0 & 20 & 0 \end{bmatrix}, R_2 = \begin{bmatrix} 0 & 38 & 0 & 15 \\ 40 & 0 & 0 & 0 \\ 0 & 0 & 37 & 0 \\ 23 & 25 & 0 & 0 \end{bmatrix}, R_3 = \begin{bmatrix} 0 & 0 & 28 & 0 \\ 0 & 0 & 44 & 0 \\ 46 & 0 & 0 & 0 \\ 0 & 0 & 0 & 0 \end{bmatrix},$$

$$R_4 = \begin{bmatrix} 0 & 49 & 0 & 0 \\ 0 & 0 & 0 & 17 \\ 0 & 36 & 0 & 0 \\ 12 & 0 & 20 & 0 \end{bmatrix}, R_5 = \begin{bmatrix} 0 & 49 & 0 & 17 \\ 24 & 0 & 0 & 0 \\ 36 & 0 & 0 & 0 \\ 0 & 0 & 12 & 0 \end{bmatrix}, R_6 = \begin{bmatrix} 0 & 0 & 26 & 0 \\ 0 & 14 & 0 & 03 \\ 14 & 0 & 0 & 0 \\ 6 & 0 & 0 & 0 \end{bmatrix},$$

$$R_7 = \begin{bmatrix} 47 & 0 & 0 & 0 \\ 0 & 2 & 0 & 0 \\ 0 & 0 & 48 & 0 \\ 30 & 0 & 0 & 33 \end{bmatrix}, R_8 = \begin{bmatrix} 0 & 5 & 0 & 0 \\ 0 & 0 & 41 & 0 \\ 39 & 0 & 0 & 0 \\ 0 & 0 & & 42 \end{bmatrix}, \text{und } R_9 = \begin{bmatrix} 0 & 0 & 0 & 19 \\ 35 & 0 & 0 & 0 \\ 0 & 9 & 0 & 0 \\ 0 & 0 & 4 & 0 \end{bmatrix},$$

wobei die mit "0" **gekennzeichnet**en Blöcke Null-Matrizen anzeigen, die mit "1" **gekennzeichnet**en Blöcke Eins-Matrizen anzeigen und die mit einer ganzen Zahl größer als 1 **gekennzeichnet**en Blöcke Eins-Matrizen anzeigen, die um die jeweilige ganze Zahl zyklisch nach rechts verschoben worden sind; und

Ersetzen (509) der Teilmatrix $R_9$ in der letzten Reihe der modifizierten Basismatrix durch eine Ersatzmatrix, die erzeugt wird, indem eine Identitäts-Matrix zu der Teilmatrix $R_9$ addiert wird.

3.  Kanalcodierverfahren in einem Kommunikationssystem, wobei das Verfahren Erzeugen einer Paritätsprüfungsmatrix eines LDPC-Codes (Low Density Parity Check Code) einschließt und die folgenden Schritte umfasst:

Festlegen (501) einer Code-Rate LDPC-Codes, wobei die Coderate 3/4 beträgt;

Erzeugen (503) einer ersten 12x12-IDCM (Integer Distance Cyclic Matrix), übertragen auf die Coderate von 3/4, wobei in der ersten Reihe vier Elemente mit einem Wert 1 in den Spalten 1, 2, 4 und 7 und in jeder folgenden Reihe in Spalten angeordnet werden, die um 1 zyklisch nach rechts verschoben sind, so dass die Elemente der ersten IDCM mit dem Wert 1 auf diagonalen Linien angeordnet sind, die in den Spalten 1, 2, 4 und 7 beginnen;

Erzeugen (503) einer zweiten 12x12-IDCM, übertragen auf die Coderate von 3/4, wobei in der ersten Reihe drei Elemente mit einem Wert 1 in den Spalten 1, 2 und 6 und in jeder folgenden Reihe in Spalten angeordnet werden, die um 1 zyklisch rechts verschoben sind, so dass die Elemente der zweiten IDCM mit dem Wert 1 auf diagonalen Linien angeordnet sind, die in den Spalten 1, 2 und 6 beginnen;

Erzeugen (503) einer dritten 12x12-IDCM, übertragen auf die Coderate von 3/4, wobei in der ersten Reihe drei Elemente mit einem Wert 1 in den Spalten 1, 3 und 8 und in jeder folgenden Reihe in Spalten angeordnet sind, die um 1 zyklisch nach rechts verschoben sind, so dass die Elemente mit dem Wert 1 der dritten IDCM auf diagonalen Linien angeordnet sind, die in den Spalten 1, 3 und 8 beginnen;

Erzeugen (503) einer vierten 12x12-IDCM, übertragen auf die Coderate von 3/4, wobei in der ersten Reihe zwei Elemente mit einem Wert 1 in den Spalten 1 und 2 und in jeder folgenden Reihe in Spalten angeordnet werden, die um 1 zyklisch nach rechts verschoben sind, so dass die Elemente mit dem Wert 1 der vierten IDCM auf diagonalen Linien angeordnet sind, die in den Spalten 1 und 2 beginnen;

Erzeugen (505) einer Basismatrix durch Kombinieren der ersten, der zweiten, der dritten und der vierten IDCM; und

Erzeugen der Paritätsprüfungs-Matrix durch:

Ersetzen (507) der IDCM, die die Basismatrix bilden, durch IDQCM (Integer Distance Quasi-Cyclic Matrices), die gebildet werden, indem die Elemente mit dem Wert 1 auf den diagonalen Linien, die in den Spalten 1, 2, 4 und 7 in der ersten Reihe der ersten IDCM beginnen, durch unregelmäßige Block-Teilmatrizen $R_1$, $R_2$, $R_3$, bzw. $R_4$ ersetzt werden, indem die Elemente mit dem Wert 1 auf den diagonalen Linien, die in den Spalten 1, 2 und 6 in der ersten Reihe der zweiten IDCM beginnen, durch unregelmäßige Block-Teilmatrizen $R_5$, $R_6$ bzw. $R_7$ ersetzt werden, indem die Elemente mit dem Wert 1 auf den diagonalen Linien, die in den Spalten 1, 3 und 8 in der ersten Reihe der dritten IDCM beginnen, durch unregelmäßige Block-Teilmatrizen

$R_8$, $R_9$ bzw. $R_{10}$ ersetzt werden und indem die Elemente mit dem Wert 1 auf den diagonalen Linien, die in den Spalten 1 und 2 in der ersten Reihe der vierten IDCM beginnen, durch unregelmäßige Block-Teilmatrizen $R_{11}$ bzw. $R_{12}$ ersetzt werden so dass eine modifizierte Basismatrix entsteht, wobei die unregelmäßigen Block-Teilmatrizen definiert sind durch:

$$R_1 = \begin{bmatrix} 50 & 0 & 2 & 0 \\ 0 & 10 & 0 & 0 \\ 67 & 0 & 0 & 50 \\ 0 & 0 & 40 & 0 \end{bmatrix}, \quad R_2 = \begin{bmatrix} 0 & 18 & 0 & 58 \\ 56 & 0 & 0 & 0 \\ 0 & 0 & 48 & 0 \\ 8 & 60 & 0 & 0 \end{bmatrix}, \quad R_3 = \begin{bmatrix} 0 & 0 & 17 & 0 \\ 0 & 55 & 0 & 0 \\ 70 & 0 & 0 & 0 \\ 0 & 0 & 30 & 0 \end{bmatrix},$$

$$R_4 = \begin{bmatrix} 0 & 5 & 0 & 0 \\ 0 & 0 & 29 & 35 \\ 0 & 11 & 0 & 0 \\ 38 & 0 & 0 & 0 \end{bmatrix}, \quad R_5 = \begin{bmatrix} 0 & 0 & 0 & 46 \\ 0 & 27 & 0 & 0 \\ 0 & 0 & 22 & 0 \\ 23 & 0 & 0 & 0 \end{bmatrix}, \quad R_6 = \begin{bmatrix} 0 & 15 & 0 & 0 \\ 0 & 0 & 0 & 39 \\ 49 & 0 & 0 & 0 \\ 0 & 0 & 24 & 0 \end{bmatrix},$$

$$R_7 = \begin{bmatrix} 44 & 0 & 0 & 0 \\ 0 & 0 & 0 & 21 \\ 0 & 0 & 16 & 0 \\ 0 & 31 & 0 & 0 \end{bmatrix}, \quad R_8 = \begin{bmatrix} 0 & 0 & 0 & 41 \\ 0 & 47 & 0 & 0 \\ 0 & 0 & 52 & 0 \\ 63 & 0 & 0 & 0 \end{bmatrix}, \quad R_9 = \begin{bmatrix} 0 & 0 & 54 & 0 \\ 0 & 10 & 0 & 34 \\ 7 & 0 & 0 & 0 \\ 0 & 64 & 0 & 0 \end{bmatrix},$$

$$R_{10} = \begin{bmatrix} 0 & 28 & 0 & 0 \\ 0 & 0 & 0 & 25 \\ 13 & 0 & 0 & 0 \\ 0 & 0 & 4 & 0 \end{bmatrix}, \quad R_{11} = \begin{bmatrix} 0 & 36 & 0 & 0 \\ 0 & 0 & 43 & 0 \\ 42 & 0 & 0 & 0 \\ 0 & 0 & 0 & 71 \end{bmatrix} \text{ und } R_{12} = \begin{bmatrix} 0 & 0 & 0 & 45 \\ 53 & 0 & 0 & 0 \\ 0 & 6 & 0 & 0 \\ 0 & 0 & 62 & 0 \end{bmatrix},$$

wobei die mit "0" **gekennzeichnet**en Blöcke Null-Matrizen anzeigen, die mit "1" **gekennzeichnet**en Blöcke Einheit-Matrizen anzeigen und die mit einer ganzen Zahl größer als 1 **gekennzeichnet**en Blöcke Einheit-Matrizen anzeigen, die um die jeweilige ganze Zahl zyklisch nach rechts verschoben worden sind; und Ersetzen (509) der Teilmatrix $R_{12}$ in der letzten Reihe der modifizierten Basismatrix durch eine Ersatzmatrix, die erzeugt wird, indem eine Identitäts-Matrix zu der Teilmatrix $R_{12}$ addiert wird.

4.  Kanalcodier-Kommunikationssystem, das eine Einrichtung zum Erzeugen einer Paritätsprüfungs-Matrix enthält, die eine Paritätsprüfungs-Matrix eines LDPC-Codes (Low Density Parity Check Code) erzeugt, und das umfasst:

    eine Einrichtung zum Festlegen (501) einer Code-Rate des LDPC-Codes, wobei die Coderate 1/2 beträgt;
    eine Einrichtung zum Erzeugen (503) einer ersten 24x24-IDCM (Integer Distance Cyclic Matrix), übertragen auf die Coderate von 1/2, wobei in der ersten Reihe fünf Elemente mit einem Wert 1 in den Spalten 1, 3, 6, 10 und 15 und in jeder folgenden Reihe in Spalten angeordnet werden, die um 1 zyklisch nach rechts verschoben sind, so dass die Elemente der ersten IDCM mit dem Wert 1 auf diagonalen Linien angeordnet sind, die in den Spalten 1, 3, 6, 10 und 15 beginnen;
    eine Einrichtung zum Erzeugen (503) einer zweiten 24x24-IDCM, übertragen auf die Coderate von 1/2, wobei in der ersten Reihe zwei Elemente mit einem Wert 1 in den Spalten 1 und 2 und in jeder folgenden Reihe in Spalten angeordnet werden, die um 1 zyklisch rechts verschoben sind, so dass die Elemente der zweiten IDCM mit dem Wert 1 auf diagonalen Linien angeordnet sind, die in den Spalten 1 und 2 beginnen eine Einrichtung zum Erzeugen (505) einer Basismatrix durch Kombinieren der ersten und der zweiten IDCM; und
    eine Einrichtung zum Erzeugen der Paritätsprüfungs-Matrix durch:

    Ersetzen (507) der IDCM, die die Basismatrix bilden, durch IDQCM (Integer Distance Quasi-Cyclic Matrices), die gebildet werden, indem die Elemente mit dem Wert 1 auf den diagonalen Linien, die in den Spalten 1, 3, 6, 10 und 15 in der ersten Reihe der ersten IDCM beginnen, durch unregelmäßige Block-Teilmatrizen

$R_1$, $R_2$, $R_3$, $R_4$ bzw. $R_5$ ersetzt werden und indem die Elemente mit dem Wert 1 auf den diagonalen Linien, die in den Spalten 1 und 2 in der ersten Reihe der zweiten IDCM beginnen, durch unregelmäßige Block-Teilmatrizen $R_6$ bzw. $R_7$ ersetzt werden, so dass eine modifizierte Basismatrix entsteht, wobei die unregelmäßigen Block-Teilmatrizen definiert sind durch:

$$R_1 = \begin{bmatrix} 28 & 0 & 0 & 0 \\ 0 & 0 & 0 & 48 \\ 1 & 0 & 0 & 0 \\ 0 & 0 & 38 & 0 \end{bmatrix},\ R_2 = \begin{bmatrix} 0 & 0 & 0 & 9 \\ 39 & 0 & 0 & 0 \\ 0 & 0 & 15 & 0 \\ 0 & 2 & 0 & 0 \end{bmatrix},\ R_3 = \begin{bmatrix} 0 & 0 & 43 & 0 \\ 0 & 0 & 0 & 0 \\ 0 & 0 & 45 & 0 \\ 41 & 0 & 0 & 0 \end{bmatrix},\ R_4 = \begin{bmatrix} 46 & 0 & 0 & 0 \\ 0 & 0 & 51 & 0 \\ 0 & 0 & 0 & 7 \\ 0 & 25 & 0 & 0 \end{bmatrix},$$

$$R_5 = \begin{bmatrix} 0 & 0 & 0 & 0 \\ 0 & 0 & 13 & 0 \\ 42 & 0 & 0 & 0 \\ 0 & 0 & 47 & 0 \end{bmatrix},\ R_6 = \begin{bmatrix} 0 & 33 & 0 & 0 \\ 0 & 0 & 8 & 0 \\ 4 & 0 & 0 & 0 \\ 0 & 0 & 0 & 18 \end{bmatrix},\ \text{und}\ R_7 = \begin{bmatrix} 0 & 0 & 0 & 44 \\ 37 & 0 & 0 & 0 \\ 0 & 12 & 0 & 0 \\ 0 & 0 & 49 & 0 \end{bmatrix},$$

wobei die mit "0" **gekennzeichnet**en Blöcke Null-Matrizen anzeigen, die mit "1" **gekennzeichnet**en Blöcke Eins-Matrizen anzeigen und die mit einer ganzen Zahl größer als 1 **gekennzeichnet**en Blöcke Eins-Matrizen anzeigen, die um die jeweilige ganze Zahl zyklisch nach rechts verschoben worden sind; und
Ersetzen (509) der Teilmatrix $R_7$ in der letzten Reihe der modifizierten Basismatrix durch eine Ersatzmatrix, die erzeugt wird, indem eine Identitäts-Matrix zu der Teilmatrix $R_7$ addiert wird.

5. Kanalcodier-Kommunikationssystem, das eine Einrichtung zum Erzeugen einer Paritätsprüfungs-Matrix enthält, die eine Paritätsprüfungs-Matrix eines LDPC-Codes (Low Density Parity Check Code) erzeugt, und das umfasst:

eine Einrichtung zum Festlegen (501) einer Code-Rate des LDPC-Codes, wobei die Coderate 2/3 beträgt;
eine Einrichtung zum Erzeugen (503) einer ersten 16x16-IDCM (Integer Distance Cyclic Matrix), übertragen auf die Coderate von 2/3, wobei in der ersten Reihe vier Elemente mit einem Wert 1 in den Spalten 1, 2, 4 und 7 und in jeder folgenden Reihe in Spalten angeordnet werden, die um 1 zyklisch nach rechts verschoben sind, so dass die Elemente der ersten IDCM mit dem Wert 1 auf diagonalen Linien angeordnet sind, die in den Spalten 1, 2, 4 und 7 beginnen;
eine Einrichtung zum Erzeugen (503) einer zweiten 16x16-IDCM, übertragen auf die Coderate von 2/3, wobei in der ersten Reihe drei Elemente mit einem Wert 1 in den Spalten 1, 5 und 10 und in jeder folgenden Reihe in Spalten angeordnet werden, die um 1 zyklisch rechts verschoben sind, so dass die Elemente der zweiten IDCM mit dem Wert 1 auf diagonalen Linien angeordnet sind, die in den Spalten 1, 5 und 10 und beginnen;
eine Einrichtung zum Erzeugen (503) einer dritten 16x16-IDCM, übertragen auf die Coderate von 2/3, wobei in der ersten Reihe zwei Elemente mit einem Wert 1 in den Spalten 1 und 2 und in jeder folgenden Reihe in Spalten angeordnet sind, die um 1 zyklisch nach rechts verschoben sind, so dass die Elemente mit dem Wert 1 der dritten IDCM auf diagonalen Linien angeordnet sind, die in den Spalten 1 und 2 beginnen;
eine Einrichtung zum Erzeugen (505) einer Basismatrix durch Kombinieren der ersten, der zweiten und der dritten IDCM; und
eine Einrichtung zum Erzeugen der Paritätsprüfungs-Matrix durch:

eine Einrichtung zum Ersetzen (507) der IDCM, die die Basismatrix bilden, durch IDQCM (Integer Distance Quasi-Cyclic Matrices), die gebildet werden, indem die Elemente mit dem Wert 1 auf den diagonalen Linien, die in den Spalten 1, 2, 4 und 7 in der ersten Reihe der ersten IDCM beginnen, durch unregelmäßige Block-Teilmatrizen $R_1$, $R_2$, $R_3$, bzw. $R_4$ ersetzt werden und indem die Elemente mit dem Wert 1 auf den diagonalen Linien, die in den Spalten 1, 5 und 10 in der ersten Reihe der zweiten IDCM beginnen, durch unregelmäßige Block-Teilmatrizen $R_5$, $R_6$ bzw. $R_7$ ersetzt werden und indem die Elemente mit dem Wert 1 auf den diagonalen Linien, die in den Spalten 1 und 2 in der ersten Reihe der dritten IDCM beginnen, durch unregelmäßige Block-Teilmatrizen $R_8$ bzw $R_9$ ersetzt werden, so dass eine modifizierte Basismatrix entsteht, wobei die unregelmäßigen Block-Teilmatrizen definiert sind durch:

$$R_1 = \begin{bmatrix} 21 & 0 & 0 & 0 \\ 0 & 22 & 0 & 0 \\ 51 & 0 & 0 & 21 \\ 0 & 0 & 20 & 0 \end{bmatrix}, R_2 = \begin{bmatrix} 0 & 38 & 0 & 15 \\ 40 & 0 & 0 & 0 \\ 0 & 0 & 37 & 0 \\ 23 & 25 & 0 & 0 \end{bmatrix}, R_3 = \begin{bmatrix} 0 & 0 & 28 & 0 \\ 0 & 0 & 44 & 0 \\ 46 & 0 & 0 & 0 \\ 0 & 0 & 0 & 0 \end{bmatrix},$$

$$R_4 = \begin{bmatrix} 0 & 49 & 0 & 0 \\ 0 & 0 & 0 & 17 \\ 0 & 36 & 0 & 0 \\ 12 & 0 & 20 & 0 \end{bmatrix}, R_5 = \begin{bmatrix} 0 & 49 & 0 & 17 \\ 24 & 0 & 0 & 0 \\ 36 & 0 & 0 & 0 \\ 0 & 0 & 12 & 0 \end{bmatrix}, R_6 = \begin{bmatrix} 0 & 0 & 26 & 0 \\ 0 & 14 & 0 & 03 \\ 14 & 0 & 0 & 0 \\ 6 & 0 & 0 & 0 \end{bmatrix},$$

$$R_7 = \begin{bmatrix} 47 & 0 & 0 & 0 \\ 0 & 2 & 0 & 0 \\ 0 & 0 & 48 & 0 \\ 30 & 0 & 0 & 33 \end{bmatrix}, R_8 = \begin{bmatrix} 0 & 5 & 0 & 0 \\ 0 & 0 & 41 & 0 \\ 39 & 0 & 0 & 0 \\ 0 & 0 & & 42 \end{bmatrix}, \text{und } R_9 = \begin{bmatrix} 0 & 0 & 0 & 19 \\ 35 & 0 & 0 & 0 \\ 0 & 9 & 0 & 0 \\ 0 & 0 & 4 & 0 \end{bmatrix},$$

wobei die mit "0" **gekennzeichnet**en Blöcke Null-Matrizen anzeigen, die mit "1" **gekennzeichnet**en Blöcke Eins-Matrizen anzeigen und die mit einer ganzen Zahl größer als 1 **gekennzeichnet**en Blöcke Eins-Matrizen anzeigen, die um die jeweilige ganze Zahl zyklisch nach rechts verschoben worden sind; und

Ersetzen (509) der Teilmatrix $R_9$ in der letzten Reihe der modifizierten Basismatrix durch eine Ersatzmatrix, die erzeugt wird, indem eine Identitäts-Matrix zu der Teilmatrix $R_9$ addiert wird.

6.  Kanalcodier-Kommunikationssystem, das eine Einrichtung zum Erzeugen einer Paritätsprüfungs-Matrix enthält, die eine Paritätsprüfungs-Matrix eines LDPC-Codes (Low Density Parity Check Code) erzeugt, und das umfasst:

eine Einrichtung zum Festlegen (501) einer Code-Rate des LDPC-Codes, wobei die Coderate 3/4 beträgt;
eine Einrichtung zum Erzeugen (503) einer ersten 12x12-IDCM (Integer Distance Cyclic Matrix), übertragen auf die Coderate von 3/4, wobei in der ersten Reihe vier Elemente mit einem Wert 1 in den Spalten 1, 2, 4 und 7 und in jeder folgenden Reihe in Spalten angeordnet werden, die um 1 zyklisch nach rechts verschoben sind, so dass die Elemente der ersten IDCM mit dem Wert 1 auf diagonalen Linien angeordnet sind, die in den Spalten 1, 2, 4 und 7 beginnen;
eine Einrichtung zum Erzeugen (503) einer zweiten 12x12-IDCM, übertragen auf die Coderate von 3/4, wobei in der ersten Reihe drei Elemente mit einem Wert 1 in den Spalten 1, 2 und 6 und in jeder folgenden Reihe in Spalten angeordnet werden, die um 1 zyklisch rechts verschoben sind, so dass die Elemente der zweiten IDCM mit dem Wert 1 auf diagonalen Linien angeordnet sind, die in den Spalten 1, 2 und 6 beginnen;
eine Einrichtung zum Erzeugen (503) einer dritten 12x12-IDCM, übertragen auf die Coderate von 3/4, wobei in der ersten Reihe drei Elemente mit einem Wert 1 in den Spalten 1, 3 und 8 und in jeder folgenden Reihe in Spalten angeordnet sind, die um 1 zyklisch nach rechts verschoben sind, so dass die Elemente mit dem Wert 1 der dritten IDCM auf diagonalen Linien angeordnet sind, die in den Spalten 1, 3 und 8 beginnen;
eine Einrichtung zum Erzeugen (503) einer vierten 12x12-IDCM, übertragen auf die Coderate von 3/4, wobei in der ersten Reihe zwei Elemente mit einem Wert 1 in den Spalten 1 und 2 und in jeder folgenden Reihe in Spalten angeordnet werden, die um 1 zyklisch nach rechts verschoben sind, so dass die Elemente mit dem Wert 1 der vierten IDCM auf diagonalen Linien angeordnet sind, die in den Spalten 1 und 2 beginnen;
eine Einrichtung zum Erzeugen (505) einer Basismatrix durch Kombinieren der ersten, der zweiten, der dritten und der vierten IDCM; und
eine Einrichtung zum Erzeugen der Paritätsprüfungs-Matrix durch:

Ersetzen (507) der IDCM, die die Basismatrix bilden, durch IDQCM (Integer Distance Quasi-Cyclic Matrices), die gebildet werden, indem die Elemente mit dem Wert 1 auf den diagonalen Linien, die in den Spalten 1, 2, 4 und 7 in der ersten Reihe der ersten IDCM beginnen, durch unregelmäßige Block-Teilmatrizen $R_1$, $R_2$, $R_3$, bzw. $R_4$ ersetzt werden, indem die Elemente mit dem Wert 1 auf den diagonalen Linien, die in den Spalten 1, 2 und 6 in der ersten Reihe der zweiten IDCM beginnen, durch unregelmäßige Block-Teilmatrizen $R_5$, $R_6$ bzw. $R_7$ ersetzt werden, indem die Elemente mit dem Wert 1 auf den diagonalen Linien, die in den Spalten 1, 3 und 8 in der ersten Reihe der dritten IDCM beginnen, durch unregelmäßige Block-Teilmatrizen $R_8$, $R_9$ bzw. $R_{10}$ ersetzt werden und indem die Elemente mit dem Wert 1 auf den diagonalen Linien, die in den Spalten 1 und 2 in der ersten Reihe der vierten IDCM beginnen, durch unregelmäßige Block-Teilmatrizen $R_{11}$ bzw. $R_{12}$ ersetzt werden so dass eine modifizierte Basismatrix entsteht wobei die unregelmäßigen Block-Teilmatrizen definiert sind durch:

$$R_1 = \begin{bmatrix} 50 & 0 & 2 & 0 \\ 0 & 10 & 0 & 0 \\ 67 & 0 & 0 & 50 \\ 0 & 0 & 40 & 0 \end{bmatrix}, R_2 = \begin{bmatrix} 0 & 18 & 0 & 58 \\ 56 & 0 & 0 & 0 \\ 0 & 0 & 48 & 0 \\ 8 & 60 & 0 & 0 \end{bmatrix}, R_3 = \begin{bmatrix} 0 & 0 & 17 & 0 \\ 0 & 55 & 0 & 0 \\ 70 & 0 & 0 & 0 \\ 0 & 0 & 30 & 0 \end{bmatrix},$$

$$R_4 = \begin{bmatrix} 0 & 5 & 0 & 0 \\ 0 & 0 & 29 & 35 \\ 0 & 11 & 0 & 0 \\ 38 & 0 & 0 & 0 \end{bmatrix}, R_5 = \begin{bmatrix} 0 & 0 & 0 & 46 \\ 0 & 27 & 0 & 0 \\ 0 & 0 & 22 & 0 \\ 23 & 0 & 0 & 0 \end{bmatrix}, R_6 = \begin{bmatrix} 0 & 15 & 0 & 0 \\ 0 & 0 & 0 & 39 \\ 49 & 0 & 0 & 0 \\ 0 & 0 & 24 & 0 \end{bmatrix},$$

$$R_7 = \begin{bmatrix} 44 & 0 & 0 & 0 \\ 0 & 0 & 0 & 21 \\ 0 & 0 & 16 & 0 \\ 0 & 31 & 0 & 0 \end{bmatrix}, R_8 = \begin{bmatrix} 0 & 0 & 0 & 41 \\ 0 & 47 & 0 & 0 \\ 0 & 0 & 52 & 0 \\ 63 & 0 & 0 & 0 \end{bmatrix}, R_9 = \begin{bmatrix} 0 & 0 & 54 & 0 \\ 0 & 10 & 0 & 34 \\ 7 & 0 & 0 & 0 \\ 0 & 64 & 0 & 0 \end{bmatrix},$$

$$R_{10} = \begin{bmatrix} 0 & 28 & 0 & 0 \\ 0 & 0 & 0 & 25 \\ 13 & 0 & 0 & 0 \\ 0 & 0 & 4 & 0 \end{bmatrix}, R_{11} = \begin{bmatrix} 0 & 36 & 0 & 0 \\ 0 & 0 & 43 & 0 \\ 42 & 0 & 0 & 0 \\ 0 & 0 & 0 & 71 \end{bmatrix}, \text{ und } R_{12} = \begin{bmatrix} 0 & 0 & 0 & 45 \\ 53 & 0 & 0 & 0 \\ 0 & 6 & 0 & 0 \\ 0 & 0 & 62 & 0 \end{bmatrix},$$

wobei die mit "0" **gekennzeichnet**en Blöcke Null-Matrizen anzeigen, die mit "1" **gekennzeichnet**en Blöcke Eins-Matrizen anzeigen und die mit einer ganzen Zahl größer als 1 **gekennzeichnet**en Blöcke Eins-Matrizen anzeigen, die um die jeweilige ganze Zahl zyklisch nach rechts verschoben worden sind; und Ersetzen (509) der Teilmatrix $R_{12}$ in der letzten Reihe der modifizierten Basismatrix durch eine Ersatzmatrix, die erzeugt wird, indem eine Identitäts-Matrix zu der Teilmatrix $R_{12}$ addiert wird.

**Revendications**

1. Procédé de codage de canal dans un système de communication, le procédé comprenant la génération d'une matrice de contrôle de parité d'un code de contrôle de parité de faible densité (LDPC) et comprenant les étapes suivantes :

établissement (501) d'un taux de code pour le code LDPC, le taux de code étant de 1/2 ;
génération (503) d'une première matrice cyclique de distance en nombre entier (IDCM) de 24x24, mappée sur le taux de code 1/2, cinq éléments ayant une valeur de 1 étant disposés au niveau des colonnes 1, 3, 6, 10 et 15 dans la première rangée et au niveau de colonnes décalées cycliquement vers la droite de 1 dans chaque rangée successive, si bien que les éléments ayant la valeur 1 de la première matrice IDCM sont disposés le long de lignes diagonales partant des colonnes 1, 3, 6, 10 et 15 ;
génération (503) d'une seconde matrice IDCM de 24x24 mappée sur le taux de code de 1/2, deux éléments ayant une valeur de 1 étant disposés au niveau des colonnes 1 et 2 dans la première rangée et au niveau de colonnes décalées cycliquement vers la droite de 1 dans chaque rangée successive, si bien que les éléments ayant la valeur 1 de la seconde matrice IDCM sont disposés le long de lignes diagonales partant des colonnes 1 et 2;
génération (505) d'une matrice de base par combinaison des première et seconde matrices IDCM ; et

génération de la matrice de contrôle de parité par :

remplacement (507) des matrices IDCM constituant la matrice de base par des matrices quasi cycliques de distance en nombre entier, IDQCM, construites en remplaçant les éléments ayant la valeur 1 le long des lignes diagonales partant des colonnes 1, 3, 6, 10 et 15 dans la première rangée de la première matrice IDCM par des sous-matrices de blocs irrégulières $R_1$, $R_2$, $R_3$, $R_4$ et $R_5$, respectivement, et en remplaçant les éléments ayant la valeur 1 le long des lignes diagonales partant des colonnes 1 et 2 dans la première rangée de la seconde matrice IDCM par des sous-matrices de blocs irrégulières $R_6$ et $R_7$, respectivement, ce qui donne lieu à une matrice de base modifiée,
les sous-matrices de blocs irrégulières étant définies par :

$$R_1 = \begin{bmatrix} 28 & 0 & 0 & 0 \\ 0 & 0 & 0 & 48 \\ 1 & 0 & 0 & 0 \\ 0 & 0 & 38 & 0 \end{bmatrix}, \quad R_2 = \begin{bmatrix} 0 & 0 & 0 & 9 \\ 39 & 0 & 0 & 0 \\ 0 & 0 & 15 & 0 \\ 0 & 2 & 0 & 0 \end{bmatrix}, \quad R_3 = \begin{bmatrix} 0 & 0 & 43 & 0 \\ 0 & 0 & 0 & 0 \\ 0 & 0 & 45 & 0 \\ 41 & 0 & 0 & 0 \end{bmatrix},$$

$$R_4 = \begin{bmatrix} 46 & 0 & 0 & 0 \\ 0 & 0 & 51 & 0 \\ 0 & 0 & 0 & 7 \\ 0 & 25 & 0 & 0 \end{bmatrix}, \quad R_5 = \begin{bmatrix} 0 & 0 & 0 & 0 \\ 0 & 0 & 13 & 0 \\ 42 & 0 & 0 & 0 \\ 0 & 0 & 47 & 0 \end{bmatrix}, \quad R_6 = \begin{bmatrix} 0 & 33 & 0 & 0 \\ 0 & 0 & 8 & 0 \\ 4 & 0 & 0 & 0 \\ 0 & 0 & 0 & 18 \end{bmatrix}, \text{ et}$$

$$R_7 = \begin{bmatrix} 0 & 0 & 0 & 44 \\ 37 & 0 & 0 & 0 \\ 0 & 12 & 0 & 0 \\ 0 & 0 & 49 & 0 \end{bmatrix}$$

dans lesquelles les blocs désignés par « 0 » représentent des matrices nulles, les blocs désignés par « 1 » représentent des matrices unités, et les blocs désignés par un nombre entier supérieur à 1 représentent des matrices unités qui ont été décalées cycliquement vers la droite par le nombre entier respectif ; et
remplacement (509) de la sous-matrice $R_7$ dans la dernière rangée de la matrice de base modifiée par une matrice de remplacement générée en ajoutant une matrice identité à la sous-matrice $R_7$.

2.  Procédé de codage de canal dans un système de communication, le procédé comprenant la génération d'une matrice de contrôle de parité d'un code de contrôle de parité de faible densité (LDPC) et comprenant les étapes suivantes :

établissement (501) d'un taux de code pour le code LDPC, le taux de code étant de 2/3 ;
génération (503) d'une première matrice cyclique de distance en nombre entier (IDCM) de 16x16, mappée sur le taux de code 2/3, quatre éléments ayant une valeur de 1 étant disposés au niveau des colonnes 1, 2, 4 et 7 dans la première rangée et an niveau de colonnes décalées cycliquement vers la droite de 1 dans chaque rangée successive, si bien que les éléments ayant la valeur 1 de la première matrice IDCM sont disposés le long de lignes diagonales partant des colonnes 1, 2, 4 et 7 ;
génération (503) d'une seconde matrice IDCM de 16x16 mappée sur le taux de code de 2/3, trois éléments ayant une valeur de 1 étant disposés au niveau des colonnes 1, 5 et 10 dans la première rangée et au niveau de colonnes décalées cycliquement vers la droite de 1 dans chaque rangée successive, si bien que les éléments ayant la valeur 1 de la seconde matrice IDCM sont disposés le long de lignes diagonales partant des colonnes 1, 5 et 10 ;
génération (503) d'une troisième matrice IDCM de 16x16 mappée sur le taux de code de 2/3, deux éléments ayant une valeur de 1 étant disposés au niveau des colonnes 1 et 2 dans la première rangée et au niveau de colonnes décalées cycliquement vers la droite de 1 dans chaque rangée successive, si bien que les éléments ayant la valeur 1 de la troisième matrice IDCM sont disposés le long de lignes diagonales partant des colonnes 1 et 2;

génération (505) d'une matrice de base par combinaison des première, seconde et troisième matrices IDCM ; et génération de la matrice de contrôle de parité par :

remplacement (507) des matrices IDCM constituant la matrice de base par des matrices quasi cycliques de distance en nombre entier, IDQCM, construites en remplaçant les éléments ayant la valeur 1 le long des lignes diagonales partant des colonnes 1, 2, 4 et 7 dans la première rangée de la première matrice IDCM par des sous-matrices de blocs irrégulières $R_1$, $R_2$, $R_3$, et $R_4$, respectivement, en remplaçant les éléments ayant la valeur 1 le long des lignes diagonales partant des colonnes 1, 5 et 10 dans la première rangée de la seconde matrice IDCM par des sous-matrices de blocs irrégulières $R_5$, $R_6$, et $R_7$, respective-ment, et en remplaçant les éléments ayant la valeur 1 le long des lignes diagonales partant des colonnes 1 et 2 dans la première rangée de la troisième matrice IDCM par des sous-matrices de blocs irrégulières $R_8$ et $R_9$, respectivement, ce qui donne lieu à une matrice de base modifiée, les sous-matrices de blocs irrégulières étant définies par :

$$
R_1 = \begin{bmatrix} 21 & 0 & 0 & 0 \\ 0 & 22 & 0 & 0 \\ 51 & 0 & 0 & 21 \\ 0 & 0 & 20 & 0 \end{bmatrix}, \quad
R_2 = \begin{bmatrix} 0 & 38 & 0 & 15 \\ 40 & 0 & 0 & 0 \\ 0 & 0 & 37 & 0 \\ 23 & 25 & 0 & 0 \end{bmatrix}, \quad
R_3 = \begin{bmatrix} 0 & 0 & 28 & 0 \\ 0 & 0 & 44 & 0 \\ 46 & 0 & 0 & 0 \\ 0 & 0 & 0 & 0 \end{bmatrix},
$$

$$
R_4 = \begin{bmatrix} 0 & 49 & 0 & 0 \\ 0 & 0 & 0 & 17 \\ 0 & 36 & 0 & 0 \\ 12 & 0 & 20 & 0 \end{bmatrix}, \quad
R_5 = \begin{bmatrix} 0 & 49 & 0 & 17 \\ 24 & 0 & 0 & 0 \\ 36 & 0 & 0 & 0 \\ 0 & 0 & 12 & 0 \end{bmatrix}, \quad
R_6 = \begin{bmatrix} 0 & 0 & 26 & 0 \\ 0 & 14 & 0 & 03 \\ 14 & 0 & 0 & 0 \\ 6 & 0 & 0 & 0 \end{bmatrix},
$$

$$
R_7 = \begin{bmatrix} 47 & 0 & 0 & 0 \\ 0 & 2 & 0 & 0 \\ 0 & 0 & 48 & 0 \\ 30 & 0 & 0 & 33 \end{bmatrix}, \quad
R_8 = \begin{bmatrix} 0 & 5 & 0 & 0 \\ 0 & 0 & 41 & 0 \\ 39 & 0 & 0 & 0 \\ 0 & 0 & & 42 \end{bmatrix}, \quad \text{et } R_9 = \begin{bmatrix} 0 & 0 & 0 & 19 \\ 35 & 0 & 0 & 0 \\ 0 & 9 & 0 & 0 \\ 0 & 0 & 4 & 0 \end{bmatrix}
$$

dans lesquelles les blocs désignés par « 0 » représentent des matrices nulles, les blocs désignés par « 1 » représentent des matrices unités, et les blocs désignés par un nombre entier supérieur à 1 représentent des matrices unités qui ont été décalées cycliquement vers la droite par le nombre entier respectif ; et remplacement (509) de la sous-matrice $R_9$ dans la dernière rangée de la matrice de base modifiée par une matrice de remplacement générée en ajoutant une matrice identité à la sous-matrice $R_9$.

3. Procédé de codage de canal dans un système de communication, le procédé comprenant la génération d'une matrice de contrôle de parité d'un code de contrôle de parité de faible densité (LDPC) et comprenant les étapes suivantes :

établissement (501) d'un taux de code pour le code LDPC, le taux de code étant de 3/4 ; génération (503) d'une première matrice cyclique de distance en nombre entier (IDCM) de 12x12, mappée sur le taux de code 3/4, quatre éléments ayant une valeur de 1 étant disposés au niveau des colonnes 1, 2, 4 et 7 dans la première rangée et au niveau de colonnes décalées cycliquement vers la droite de 1 dans chaque rangée successive, si bien que les éléments ayant la valeur 1 de la première matrice IDCM sont disposés le long de lignes diagonales partant des colonnes 1, 2, 4 et 7 ; génération (503) d'une seconde matrice IDCM de 12x12 mappée sur le taux de code de 3/4, trois éléments ayant une valeur de 1 étant disposés au niveau des colonnes 1, 2 et 6 dans la première rangée et au niveau de colonnes décalées cycliquement vers la droite de 1 dans chaque rangée successive, si bien que les éléments ayant la valeur 1 de la seconde matrice IDCM sont disposés le long de lignes diagonales partant des colonnes 1, 2 et 6;

génération (503) d'une troisième matrice IDCM de 12x12 mappée sur le taux de code de 3/4, trois éléments ayant une valeur de 1 étant disposés au niveau des colonnes 1, 3 et 8 dans la première rangée et au niveau de colonnes décalées cycliquement vers la droite de 1 dans chaque rangée successive, si bien que les éléments ayant la valeur 1 de la troisième matrice IDCM sont disposés le long de lignes diagonales partant des colonnes 1, 3 et 8;

génération (503) d'une quatrième matrice IDCM de 12x12 mappée sur le taux de code de 3/4, deux éléments ayant une valeur de 1 étant disposés au niveau des colonnes 1 et 2 dans la première rangée et au niveau de colonnes décalées cycliquement vers la droite de 1 dans chaque rangée successive, si bien que les éléments ayant la valeur 1 de la quatrième matrice IDCM sont disposés le long de lignes diagonales partant des colonnes 1 et 2 ;

génération (505) d'une matrice de base par combinaison des première, seconde, troisième et quatrième matrices IDCM ; et

génération de la matrice de contrôle de parité par :

remplacement (507) des matrices IDCM constituant la matrice de base par des matrices quasi cycliques de distance en nombre entier, IDQCM, construites en remplaçant les éléments ayant la valeur 1 le long des lignes diagonales partant des colonnes 1, 2, 4 et 7 dans la première rangée de la première matrice IDCM par des sous-matrices de blocs irrégulières $R_1$, $R_2$, $R_3$, et $R_4$, respectivement, en remplaçant les éléments ayant la valeur 1 le long des lignes diagonales partant des colonnes 1, 2 et 6 dans la première rangée de la seconde matrice IDCM par des sous-matrices de blocs irrégulières $R_5$, $R_6$, et $R_7$, respectivement, en remplaçant les éléments ayant la valeur 1 le long des lignes diagonales partant des colonnes 1, 3 et 8 dans la première rangée de la troisième matrice IDCM par des sous-matrices de blocs irrégulières $R_8$, $R_9$, et $R_{10}$, respectivement, et en remplaçant les éléments ayant la valeur 1 le long des lignes diagonales partant des colonnes 1 et 2 dans la première rangée de la quatrième matrice IDCM par des sous-matrices de blocs irrégulières $R_{11}$ et $R_{12}$, respectivement, ce qui donne lieu à une matrice de base modifiée, les sous-matrices de blocs irrégulières étant définies par :

$$R_1 = \begin{bmatrix} 50 & 0 & 2 & 0 \\ 0 & 10 & 0 & 0 \\ 67 & 0 & 0 & 50 \\ 0 & 0 & 40 & 0 \end{bmatrix}, \quad R_2 = \begin{bmatrix} 0 & 18 & 0 & 58 \\ 56 & 0 & 0 & 0 \\ 0 & 0 & 48 & 0 \\ 8 & 60 & 0 & 0 \end{bmatrix}, \quad R_3 = \begin{bmatrix} 0 & 0 & 17 & 0 \\ 0 & 55 & 0 & 0 \\ 70 & 0 & 0 & 0 \\ 0 & 0 & 30 & 0 \end{bmatrix},$$

$$R_4 = \begin{bmatrix} 0 & 5 & 0 & 0 \\ 0 & 0 & 29 & 35 \\ 0 & 11 & 0 & 0 \\ 38 & 0 & 0 & 0 \end{bmatrix}, \quad R_5 = \begin{bmatrix} 0 & 0 & 0 & 46 \\ 0 & 27 & 0 & 0 \\ 0 & 0 & 22 & 0 \\ 23 & 0 & 0 & 0 \end{bmatrix}, \quad R_6 = \begin{bmatrix} 0 & 15 & 0 & 0 \\ 0 & 0 & 0 & 39 \\ 49 & 0 & 0 & 0 \\ 0 & 0 & 24 & 0 \end{bmatrix},$$

$$R_7 = \begin{bmatrix} 44 & 0 & 0 & 0 \\ 0 & 0 & 0 & 21 \\ 0 & 0 & 16 & 0 \\ 0 & 31 & 0 & 0 \end{bmatrix}, \quad R_8 = \begin{bmatrix} 0 & 0 & 0 & 41 \\ 0 & 47 & 0 & 0 \\ 0 & 0 & 52 & 0 \\ 63 & 0 & 0 & 0 \end{bmatrix}, \quad R_9 = \begin{bmatrix} 0 & 0 & 54 & 0 \\ 0 & 10 & 0 & 34 \\ 7 & 0 & 0 & 0 \\ 0 & 64 & 0 & 0 \end{bmatrix},$$

$$R_{10} = \begin{bmatrix} 0 & 28 & 0 & 0 \\ 0 & 0 & 0 & 25 \\ 13 & 0 & 0 & 0 \\ 0 & 0 & 4 & 0 \end{bmatrix}, \quad R_{11} = \begin{bmatrix} 0 & 36 & 0 & 0 \\ 0 & 0 & 43 & 0 \\ 42 & 0 & 0 & 0 \\ 0 & 0 & 0 & 71 \end{bmatrix}, \quad \text{et } R_{12} = \begin{bmatrix} 0 & 0 & 0 & 45 \\ 53 & 0 & 0 & 0 \\ 0 & 6 & 0 & 0 \\ 0 & 0 & 62 & 0 \end{bmatrix}.$$

dans lesquelles les blocs désignés par « 0 » représentent des matrices nulles, les blocs désignés par « 1 » représentent des matrices unités, et les blocs désignés par un nombre entier supérieur à 1 représentent des matrices unités qui ont été décalées cycliquement vers la droite par le nombre entier respectif ; et remplacement (509) de la sous-matrice $R_{12}$ dans la dernière rangée de la matrice de base modifiée par une matrice de remplacement générée en ajoutant une matrice identité à la sous-matrice $R_{12}$.

**4.** Système de communication à codage de canal comprenant un générateur de matrice de contrôle de parité générant une matrice de contrôle de parité d'un code de contrôle de parité de faible densité (LDPC) et comprenant :

des moyens pour établir (501) un taux de code pour le code LDPC, le taux de code étant de 1/2 ;
des moyens pour générer (503) une première matrice cyclique de distance en nombre entier (IDCM) de 24x24, mappée sur le taux de code 1/2, cinq éléments ayant une valeur de 1 étant disposés au niveau des colonnes 1, 3, 6, 10 et 15 dans la première rangée et au niveau de colonnes décalées cycliquement vers la droite de 1 dans chaque rangée successive, si bien que les éléments ayant la valeur 1 de la première matrice IDCM sont disposés le long de lignes diagonales partant des colonnes 1, 3, 6, 10 et 15 ;
des moyens pour générer (503) une seconde matrice IDCM de 24x24 mappée sur le taux de code de 1/2, deux éléments ayant une valeur de 1 étant disposés au niveau des colonnes 1 et 2 dans la première rangée et au niveau de colonnes décalées cycliquement vers la droite de 1 dans chaque rangée successive, si bien que les éléments ayant la valeur 1 de la seconde matrice IDCM sont disposés le long de lignes diagonales partant des colonnes 1 et 2 ;
des moyens pour générer (505) une matrice de base par combinaison des première et seconde matrices IDCM ; et
des moyens pour générer la matrice de contrôle de parité par :

remplacement (507) des matrices IDCM constituant la matrice de base par des matrices quasi cycliques de distance en nombre entier, IDQCM, construites en remplaçant les éléments ayant la valeur 1 le long des lignes diagonales partant des colonnes 1, 3, 6, 10 et 15 dans la première rangée de la première matrice IDCM par des sous-matrices de blocs irrégulières $R_1$, $R_2$, $R_3$, $R_4$ et $R_5$, respectivement, et en remplaçant les éléments ayant la valeur 1 le long des lignes diagonales partant des colonnes 1 et 2 dans la première rangée de la seconde matrice IDCM par des sous-matrices de blocs irrégulières $R_6$ et $R_7$, respectivement, ce qui donne lieu à une matrice de base modifiée,

les sous-matrices de blocs irrégulières étant définies par :

$$R_1 = \begin{bmatrix} 28 & 0 & 0 & 0 \\ 0 & 0 & 0 & 48 \\ 1 & 0 & 0 & 0 \\ 0 & 0 & 38 & 0 \end{bmatrix}, R_2 = \begin{bmatrix} 0 & 0 & 0 & 9 \\ 39 & 0 & 0 & 0 \\ 0 & 0 & 15 & 0 \\ 0 & 2 & 0 & 0 \end{bmatrix}, R_3 = \begin{bmatrix} 0 & 0 & 43 & 9 \\ 0 & 0 & 0 & 0 \\ 0 & 0 & 45 & 0 \\ 41 & 0 & 0 & 0 \end{bmatrix},$$

$$R_4 = \begin{bmatrix} 46 & 0 & 0 & 0 \\ 0 & 0 & 51 & 0 \\ 0 & 0 & 0 & 7 \\ 0 & 25 & 0 & 0 \end{bmatrix}, R_5 = \begin{bmatrix} 0 & 0 & 0 & 0 \\ 0 & 0 & 13 & 0 \\ 42 & 0 & 0 & 0 \\ 0 & 0 & 47 & 0 \end{bmatrix}, R_6 = \begin{bmatrix} 0 & 33 & 0 & 0 \\ 0 & 0 & 8 & 0 \\ 4 & 0 & 0 & 0 \\ 0 & 0 & 0 & 18 \end{bmatrix}, \text{ et}$$

$$R_7 = \begin{bmatrix} 0 & 0 & 0 & 44 \\ 37 & 0 & 0 & 0 \\ 0 & 12 & 0 & 0 \\ 0 & 0 & 49 & 0 \end{bmatrix}$$

dans lesquelles les blocs désignés par « 0 » représentent des matrices nulles, les blocs désignés par « 1 » représentent des matrices unités, et les blocs désignés par un nombre entier supérieur à 1 représentent des matrices unités qui ont été décalées cycliquement vers la droite par le nombre entier respectif ; et remplacement (509) de la sous-matrice $R_7$ dans la dernière rangée de la matrice de base modifiée par une matrice de remplacement générée en ajoutant une matrice identité à la sous-matrice $R_7$.

5. Système de communication à codage de canal comprenant un générateur de matrice de contrôle de parité générant une matrice de contrôle de parité d'un code de contrôle de parité de faible densité (LDPC) et comprenant :

des moyens pour établir (501) un taux de code pour le code LDPC, le taux de code étant de 2/3 ;
des moyens pour générer (503) une première matrice cyclique de distance en nombre entier (IDCM) de 16x16, mappée sur le taux de code 2/3, quatre éléments ayant une valeur de 1 étant disposés au niveau des colonnes 1, 2, 4 et 7 dans la première rangée et au niveau de colonnes décalées cycliquement vers la droite de 1 dans chaque rangée successive, si bien que les éléments ayant la valeur 1 de la première matrice IDCM sont disposés le long de lignes diagonales partant des colonnes 1, 2, 4 et 7 ;
des moyens pour générer (503) une seconde matrice IDCM de 16x16 mappée sur le taux de code de 2/3, trois éléments ayant une valeur de 1 étant disposés au niveau des colonnes 1, 5 et 10 dans la première rangée et au niveau de colonnes décalées cycliquement vers la droite de 1 dans chaque rangée successive, si bien que les éléments ayant la valeur 1 de la seconde matrice IDCM sont disposés le long de lignes diagonales partant des colonnes 1, 5 et 10 ;
des moyens pour générer (503) une troisième matrice IDCM de 16x16 mappée sur le taux de code de 2/3, deux éléments ayant une valeur de 1 étant disposés au niveau des colonnes 1 et 2 dans la première rangée et au niveau de colonnes décalées cycliquement vers la droite de 1 dans chaque rangée successive, si bien que les éléments ayant la valeur 1 de la troisième matrice IDCM sont disposés le long de lignes diagonales partant des colonnes 1 et 2 ;
des moyens pour générer (505) une matrice de base par combinaison des première, seconde et troisième matrices IDCM ; et des moyens pour générer la matrice de contrôle de parité par :

remplacement (507) des matrices IDCM constituant la matrice de base par des matrices quasi cycliques de distance en nombre entier, IDQCM, construites en remplaçant les éléments ayant la valeur 1 le long des lignes diagonales partant des colonnes 1, 2, 4 et 7 dans la première rangée de la première matrice IDCM par des sous-matrices de blocs irrégulières $R_1$, $R_2$, $R_3$, et $R_4$, respectivement, en remplaçant les éléments ayant la valeur 1 le long des lignes diagonales partant des colonnes 1, 5 et 10 dans la première rangée de la seconde matrice IDCM par des sous-matrices de blocs irrégulières $R_5$, $R_6$, et $R_7$, respective- ment, et en remplaçant les éléments ayant la valeur 1 le long des lignes diagonales partant des colonnes 1 et 2 dans la première rangée de la troisième matrice IDCM par des sous-matrices de blocs irrégulières $R_8$ et $R_9$, respectivement, ce qui donne lieu à une matrice de base modifiée, les sous-matrices de blocs irrégulières étant définies par :

$$R_1 = \begin{bmatrix} 21 & 0 & 0 & 0 \\ 0 & 22 & 0 & 0 \\ 51 & 0 & 0 & 21 \\ 0 & 0 & 20 & 0 \end{bmatrix}, \quad R_2 = \begin{bmatrix} 0 & 38 & 0 & 15 \\ 40 & 0 & 0 & 0 \\ 0 & 0 & 37 & 0 \\ 23 & 25 & 0 & 0 \end{bmatrix}, \quad R_3 = \begin{bmatrix} 0 & 0 & 28 & 0 \\ 0 & 0 & 44 & 0 \\ 46 & 0 & 0 & 0 \\ 0 & 0 & 0 & 0 \end{bmatrix},$$

$$R_4 = \begin{bmatrix} 0 & 49 & 0 & 0 \\ 0 & 0 & 0 & 17 \\ 0 & 36 & 0 & 0 \\ 12 & 0 & 20 & 0 \end{bmatrix}, \quad R_5 = \begin{bmatrix} 0 & 49 & 0 & 17 \\ 24 & 0 & 0 & 0 \\ 36 & 0 & 0 & 0 \\ 0 & 0 & 12 & 0 \end{bmatrix}, \quad R_6 = \begin{bmatrix} 0 & 0 & 26 & 0 \\ 0 & 14 & 0 & 03 \\ 14 & 0 & 0 & 0 \\ 6 & 0 & 0 & 0 \end{bmatrix},$$

$$R_7 = \begin{bmatrix} 47 & 0 & 0 & 0 \\ 0 & 2 & 0 & 0 \\ 0 & 0 & 48 & 0 \\ 30 & 0 & 0 & 33 \end{bmatrix}, \quad R_8 = \begin{bmatrix} 0 & 5 & 0 & 0 \\ 0 & 0 & 41 & 0 \\ 39 & 0 & 0 & 0 \\ 0 & 0 & & 42 \end{bmatrix}, \quad \text{et } R_9 = \begin{bmatrix} 0 & 0 & 0 & 19 \\ 35 & 0 & 0 & 0 \\ 0 & 9 & 0 & 0 \\ 0 & 0 & 4 & 0 \end{bmatrix}$$

dans lesquelles les blocs désignés par « 0 » représentent des matrices nulles, les blocs désignés par « 1 » représentent des matrices unités, et les blocs désignés par un nombre entier supérieur à 1 représentent des matrices unités qui ont été décalées cycliquement vers la droite par le nombre entier respectif ; et remplacement (509) de la sous-matrice $R_9$ dans la dernière rangée de la matrice de base modifiée par une matrice de remplacement générée en ajoutant une matrice identité à la sous-matrice $R_9$.

6. Système de communication à codage de canal comprenant un générateur de matrice de contrôle de parité générant une matrice de contrôle de parité d'un code de contrôle de parité de faible densité (LDPC) et comprenant :

des moyens pour établir (501) un taux de code pour le code LDPC, le taux de code étant de 3/4 ; des moyens pour générer (503) une première matrice cyclique de distance en nombre entier (IDCM) de 12x12, mappée sur le taux de code 3/4, quatre éléments ayant une valeur de 1 étant disposés au niveau des colonnes 1, 2, 4 et 7 dans la première rangée et au niveau de colonnes décalées cycliquement vers la droite de 1 dans chaque rangée successive, si bien que les éléments ayant la valeur 1 de la première matrice IDCM sont disposés le long de lignes diagonales partant des colonnes 1, 2, 4 et 7 ; des moyens pour générer (503) une seconde matrice IDCM de 12x12 mappée sur le taux de code de 3/4, trois éléments ayant une valeur de 1 étant disposés au niveau des colonnes 1, 2 et 6 dans la première rangée et au niveau de colonnes décalées cycliquement vers la droite de 1 dans chaque rangée successive, si bien que les éléments ayant la valeur 1 de la seconde matrice IDCM sont disposés le long de lignes diagonales partant des colonnes 1, 2 et 6 ; des moyens pour générer (503) une troisième matrice IDCM de 12x12 mappée sur le taux de code de 3/4, trois éléments ayant une valeur de 1 étant disposés au niveau des colonnes 1, 3 et 8 dans la première rangée et au niveau de colonnes décalées cycliquement vers la droite de 1 dans chaque rangée successive, si bien que les éléments ayant la valeur 1 de la troisième matrice IDCM sont disposés le long de lignes diagonales partant des colonnes 1, 3 et 8 ;

des moyens pour générer (503) une quatrième matrice IDCM de 12x12 mappée sur le taux de code de 3/4, deux éléments ayant une valeur de 1 étant disposés au niveau des colonnes 1 et 2 dans la première rangée et au niveau de colonnes décalées cycliquement vers la droite de 1 dans chaque rangée successive, si bien que les éléments ayant la valeur 1 de la quatrième matrice IDCM sont disposés le long de lignes diagonales partant des colonnes 1 et 2 ;

des moyens pour générer (505) une matrice de base par combinaison des première, seconde, troisième et quatrième matrices IDCM ; et

des moyens pour générer la matrice de contrôle de parité par :

remplacement (507) des matrices IDCM constituant la matrice de base par des matrices quasi cycliques de distance en nombre entier, IDQCM, construites en remplaçant les éléments ayant la valeur 1 le long des lignes diagonales partant des colonnes 1, 2, 4 et 7 dans la première rangée de la première matrice IDCM par des sous-matrices de blocs irrégulières $R_1$, $R_2$, $R_3$, et $R_4$, respectivement, en remplaçant les éléments ayant la Valeur 1 le long des lignes diagonales partant des colonnes 1, 2 et 6 dans la première rangée de la seconde matrice IDCM par des sous-matrices de blocs irrégulières $R_5$, $R_6$, et $R_7$, respective-ment, en remplaçant les éléments ayant la valeur 1 le long des lignes diagonales partant des colonnes 1, 3 et 8 dans la première rangée de la troisième matrice IDCM par des sous-matrices de blocs irrégulières $R_8$, $R_9$, et $R_{10}$, respectivement, et en remplaçant les éléments ayant la valeur 1 le long des lignes diagonales partant des colonnes 1 et 2 dans la première rangée de la quatrième matrice IDCM par des sous-matrices de blocs irrégulières $R_{11}$ et $R_{12}$, respectivement, ce qui donne lieu à une matrice de base modifiée, les sous-matrices de blocs irrégulières étant définies par :

$$R_1 = \begin{bmatrix} 50 & 0 & 2 & 0 \\ 0 & 10 & 0 & 0 \\ 67 & 0 & 0 & 50 \\ 0 & 0 & 40 & 0 \end{bmatrix},\ R_2 = \begin{bmatrix} 0 & 18 & 0 & 58 \\ 56 & 0 & 0 & 0 \\ 0 & 0 & 48 & 0 \\ 8 & 60 & 0 & 0 \end{bmatrix},\ R_3 = \begin{bmatrix} 0 & 0 & 17 & 0 \\ 0 & 55 & 0 & 0 \\ 70 & 0 & 0 & 0 \\ 0 & 0 & 30 & 0 \end{bmatrix},$$

$$R_4 = \begin{bmatrix} 0 & 5 & 0 & 0 \\ 0 & 0 & 29 & 35 \\ 0 & 11 & 0 & 0 \\ 38 & 0 & 0 & 0 \end{bmatrix},\ R_5 = \begin{bmatrix} 0 & 0 & 0 & 46 \\ 0 & 27 & 0 & 0 \\ 0 & 0 & 22 & 0 \\ 23 & 0 & 0 & 0 \end{bmatrix},\ R_6 = \begin{bmatrix} 0 & 15 & 0 & 0 \\ 0 & 0 & 0 & 39 \\ 49 & 0 & 0 & 0 \\ 0 & 0 & 24 & 0 \end{bmatrix},$$

$$R_7 = \begin{bmatrix} 44 & 0 & 0 & 0 \\ 0 & 0 & 0 & 21 \\ 0 & 0 & 16 & 0 \\ 0 & 31 & 0 & 0 \end{bmatrix},\ R_8 = \begin{bmatrix} 0 & 0 & 0 & 41 \\ 0 & 47 & 0 & 0 \\ 0 & 0 & 52 & 0 \\ 63 & 0 & 0 & 0 \end{bmatrix},\ R_9 = \begin{bmatrix} 0 & 0 & 54 & 0 \\ 0 & 10 & 0 & 34 \\ 7 & 0 & 0 & 0 \\ 0 & 64 & 0 & 0 \end{bmatrix},$$

$$R_{10} = \begin{bmatrix} 0 & 28 & 0 & 0 \\ 0 & 0 & 0 & 25 \\ 13 & 0 & 0 & 0 \\ 0 & 0 & 4 & 0 \end{bmatrix},\ R_{11} = \begin{bmatrix} 0 & 36 & 0 & 0 \\ 0 & 0 & 43 & 0 \\ 42 & 0 & 0 & 0 \\ 0 & 0 & 0 & 71 \end{bmatrix},\ et\ R_{12} = \begin{bmatrix} 0 & 0 & 0 & 45 \\ 53 & 0 & 0 & 0 \\ 0 & 6 & 0 & 0 \\ 0 & 0 & 62 & 0 \end{bmatrix}$$

dans lesquelles les blocs désignés par « 0 » représentent des matrices nulles, les blocs désignés par « 1 » représentent des matrices unités, et les blocs désignés par un nombre entier supérieur à 1 représentent des matrices unités qui ont été décalées cycliquement vers la droite par le nombre entier respectif ; et remplacement (509) de la sous-matrice $R_{12}$ dans la dernière rangée de la matrice de base modifiée par une matrice de remplacement générée en ajoutant une matrice identité à la sous-matrice $R_{12}$.

FIG.1

FIG.2

FIG.3

FIG.4

START

SET CODE RATE ~501

SELECT IDCMs ~503

GENERATE BASE MATRIX ~505

REPLACE IDCMs OF
BASE MATRIX WITH IDQCMs ~507

GENERATE PARITY CHECK MATRIX ~509

END

FIG.5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **Classon B et al.** *LDPC coding for OFDMA PHY,* 30 August 2004
- **Hao Zhong et al.** Design of VLSI implemention-oriented LDPC codes. *Proc. Vehicular Technology Conference,* 06 October 2003, vol. 1, 670-673
- **Hocevar D.** LDPC code construction with flexible hardware implementation. *PROC. 2003 IEEE International Conference on Communications,* 11 May 2003, vol. 1 (5), 2708-2712
- **Fossorier M.** Quasi-caclic low-density parity-check codes from circulant permutation matrices. *IEEE Transactions on Information Theory,* 01 August 2004, 1788-1793